(19) **Europäisches Patentamt / European Patent Office / Office européen des brevets**

(11) **EP 1 790 083 B1**

(12) **EUROPEAN PATENT SPECIFICATION**

(45) Date of publication and mention
of the grant of the patent:
**12.01.2011 Bulletin 2011/02**

(21) Application number: **05789316.6**

(22) Date of filing: **03.08.2005**

(51) Int Cl.:
*H03M 13/11* (2006.01)    *H04L 1/00* (2006.01)

(86) International application number:
**PCT/US2005/027447**

(87) International publication number:
**WO 2006/020460 (23.02.2006 Gazette 2006/08)**

(54) **CODE DESIGN AND IMPLEMENTATION IMPROVEMENTS FOR LOW DENSITY PARITY CHECK CODES FOR MULTIPLE-INPUT MULTIPLE-OUTPUT CHANNELS**

CODEENTWURFS- UND IMPLEMENTIERUNGSVERBESSERUNGEN FÜR WENIG DICHTE PARITÄTSPRÜFCODES FÜR KANÄLE MIT MEHREREN EINGÄNGEN UND MEHREREN AUSGÄNGEN

AMELIORATIONS DE CONCEPTION DE CODE ET DE MISE EN OEUVRE POUR DES CODES DE VERIFICATION DE PARITE A FAIBLE DENSITE DE CANAUX A ENTREES MULTIPLES ET A SORTIES MULTIPLES

(84) Designated Contracting States:
**AT BE BG CH CY CZ DE DK EE ES FI FR GB GR HU IE IS IT LI LT LU LV MC NL PL PT RO SE SI SK TR**

(30) Priority: **13.08.2004 US 601533 P**
**08.02.2005 US 651131 P**
**14.02.2005 US 652597 P**
**24.02.2005 US 656003 P**
**02.03.2005 US 657860 P**

(43) Date of publication of application:
**30.05.2007 Bulletin 2007/22**

(73) Proprietor: **DTVG LICENSING, INC**
**El Segundo CA 90245 (US)**

(72) Inventors:
• **EROZ, Mustafa**
**Germantown, MD 20874 (US)**
• **LEE, Lin-Nan**
**Potomac, MD 20854 (US)**
• **SUN, Feng-Wen**
**Germantown, MD 20874 (US)**

(74) Representative: **Jackson, Richard Eric et al**
**Carpmaels & Ransford**
**One Southampton Row**
**London**
**WC1B 5HA (GB)**

(56) References cited:
| WO-A-02/099976 | WO-A-2004/019268 |
| US-A1- 2003 037 298 | US-A1- 2004 054 960 |
| US-A1- 2004 221 223 | US-A1- 2005 154 958 |
| US-A1- 2005 235 195 | US-A1- 2005 265 387 |
| US-B1- 6 715 121 | |

• ETSI: "Digital Video Broadcasting (DVB); Second generation framing structure, channel coding and modulation systems for Broadcasting, Interactive Services, News Gathering and other broadband satellite applications" ETSI DRAFTS, LIS, 1 June 2004 (2004-06-01), page complete, XP002325753 ISSN: 0000-0002
• LU B ET AL: "Performance Analysis and Design Optimization of LDPC-Coded MIMO OFDM Systems" IEEE TRANSACTIONS ON SIGNAL PROCESSING, IEEE SERVICE CENTER, NEW YORK, NY, US, vol. 52, no. 2, 1 February 2004 (2004-02-01), pages 348-361, XP011105722 ISSN: 1053-587X
• HEUNG-NO LEE: "LDPC coded modulation MIMO OFDM transceiver: performance comparison with MAP equalization" PROC., IEEE VEHICULAR TECHNOLOGY CONFERENCE, VTC 2003-SPRING, JEJU, KOREA, vol. 2, 22 April 2003 (2003-04-22), - 25 April 2003 (2003-04-25) pages 1178-1182, XP010862634 ISBN: 978-0-7803-7757-8

- VASIC B.: "Combinatorial constructions of low-density parity check codes for iterative decoding" PROC., IEEE INTERNATIONAL SYMPOSIUM ON INFORMATION THEORY, ISIT 02, LAUSANNE, SWITZERLAND, 30 June 2002 (2002-06-30), - 5 July 2002 (2002-07-05) pages 312-312, XP010602023 ISBN: 978-0-7803-7501-7
- LI PING ET AL: "Low density parity check codes with semi-random parity check matrix" ELECTRONICS LETTERS, IEE STEVENAGE, GB, vol. 35, no. 1, 7 January 1999 (1999-01-07), pages 38-39, XP006011650 ISSN: 0013-5194
- ECHARD R ET AL: "THE PI-ROTATION LOW-DENSITY PARITY CHECK CODES" GLOBECOM'01. 2001 IEEE GLOBAL TELECOMMUNICATIONS CONFERENCE. SAN ANTONIO, TX, NOV. 25 - 29, 2001; [IEEE GLOBAL TELECOMMUNICATIONS CONFERENCE], NEW YORK, NY : IEEE, US, 25 November 2001 (2001-11-25), pages 980-984, XP001099251 ISBN: 978-0-7803-7206-1

## Description

BACKGROUND OF THE INVENTION

1. Field of the Invention.

The present invention relates generally to a digital signal delivery systems, and in particular, to design and implementation for Low Density Parity Check (LDPC) codes for multiple-input, multiple-output channels within a digital signal delivery system.

2. Description of the Related Art.

Radio Frequency (RF) transmission of information has become commonplace. Typically, a single transmit antenna sends a signal which can be received by one or more receive antennas. Examples of such systems include satellite broadcasts, such as satellite television broadcasting, radio, and cellular telephone systems.

Because of the ease of use of such systems, larger and larger demands for higher speed data transfer through such systems have taken place. Wireless internet access, which requires the transfer of large amounts of data for pictures, audio, and other data requires a large throughput via a single transmit antenna system. Many of these systems are now reaching their data throughput limits, making it difficult to provide wireless data transfer in areas that such services are desired.

There is a current movement to have Multiple Input Multiple Output (MIMO) systems that employ multiple transmit antennas and multiple receive antennas to increase the data throughput. Examples of MIMO systems are wireless Local Area Networks (LANs), Bluetooth networks, and high-speed wireless (Wi-Fi) networks. MIMO systems use multiple signal paths, which in standard systems would cause multipath errors and interference, to transmit additional data from one place to another. Algorithms for properly transmitting and subsequently recombining the MIMO transmitted data at the receiver must be conceived and transmitted along with the MIMO data for such systems to properly function.

MIMO systems theoretically double the spectral efficiency compared with that of single transmit antenna systems. Just as with single transmit antenna systems, the data frames in a MIMO system are coded in such a manner that they can interfere with each other, and MIMO receivers cannot tell which packets of data goes first, or whether the data within a given frame is corrupted by constructive or destructive interference. Such interference is called "co-channel" interference, where one channel of data interferes with the reception and demodulation of another channel of data. In practical applications, the co-channel interference may also stem from transmission of other system operators or other spot transmission beams in a MIMO system. As MIMO systems transmit more data, the interference between data packets will increase, and, as such, the quality of the signal reception will be poorer.

To ensure that transmission systems can properly decode transmitted data, error correction codes, specifically, Forward Error Correction (FEC) codes are used. However, in MIMO systems, FEC codes cannot be chosen randomly because of the potential interference of these codes with each other.

Traditionally, the negative effects of such interference have been minimized by redesigning the frequency assignments assigned to the various transmitters and receivers. However, since the frequencies are fixed by standard, frequency reassignment or frequency reuse will not alleviate the problem beyond a certain point.

It can be seen, then, that there is a need in the art to minimize the interference in a broadcasting system. It can also be seen that there is a need in the art for proper selection of FEC codes in a MIMO system.

SUMMARY OF THE INVENTION

To minimize the limitations in the prior art, and to minimize other limitations that will become apparent upon reading and understanding the present specification, the present invention discloses method and system for designing LDPC codes. A method in accordance with the present invention is defined in the appendant claims.

A system in accordance with the present invention is defined in the appendant claims.

Other features and advantages are inherent in the system and method claimed and disclosed or will become apparent to those skilled in the art from the following detailed description and its accompanying drawings.

BRIEF DESCRIPTION OF THE DRAWINGS

Referring now to the drawings in which like reference numbers represent corresponding parts throughout:

FIG. 1 illustrates a system block diagram of an LDPC-coded MIMO system of the present invention;
FIG. 2 illustrates a submatrix of the parity check matrix of the present invention; and

FIGS. 3A-3C illustrate simulations of the performance of the present invention;

FIGS. 4A-4C illustrate simulations of the performance of short block length LDPC codes of the present invention; and

FIG. 5 illustrates a flowchart illustrating an exemplary method of the present invention.

## DETAILED DESCRIPTION OF PREFERRED EMBODIMENTS

In the following description, reference is made to the accompanying drawings which form a part hereof, and which show, by way of illustration, several embodiments of the present invention. It is understood that other embodiments may be utilized and structural changes may be made without departing from the scope of the present invention.

### Overview

The present invention uses Low Density Parity Check (LDPC) codes to increase the performance of MIMO systems, within a few dB of the theoretical limit of such systems, without unduly increasing the complexity of the circuitry needed to generate and decode the LDPC codes of the present invention.

LDPC codes were discovered by Gallager in 1962, but they were not given much attention for decades as the technology at the time was not mature for efficient implementation. Motivated by the success of iterative decoding of turbo codes, LDPC codes were reintroduced in 1995, generating great interest and activity on the subject. Unlike turbo codes, LDPC codes have an easily parallelizable decoding algorithm which consists of simple operations such as addition, comparison and table look-up. Despite the simplicity of the decoding algorithm and operations, the challenge in the design is how to establish the communication between "randomly" distributed bit nodes and check nodes.

A fully parallel architecture where there are as many physical nodes in the circuit as the logical nodes of the code becomes rapidly infeasible with increasing block size due to complexity of interconnections between the nodes. However, for a partially parallel architecture, where a small number of physical nodes are re-used to serve all the logical nodes, the main problem is to access relevant information for the logical nodes in process, fast enough from memory in high speed applications.

Multiple-antenna input multiple-antenna output systems have recently gained popularity as an effective way to combat multi-path fading channels. Space time codes were introduced to maximize the diversity and coding gain for these systems. However, the coding gain delivered by reasonable complexity space-time codes are not sufficient. As a result, performance of space-time codes fall far away from what can be achieved.

The present invention replaces the space-time codes with LDPC codes to improve the performance of MIMO systems. Further, the present invention illustrates the method for generating proper LDPC codes for such systems to increase data throughput and improve performance.

### System Diagram

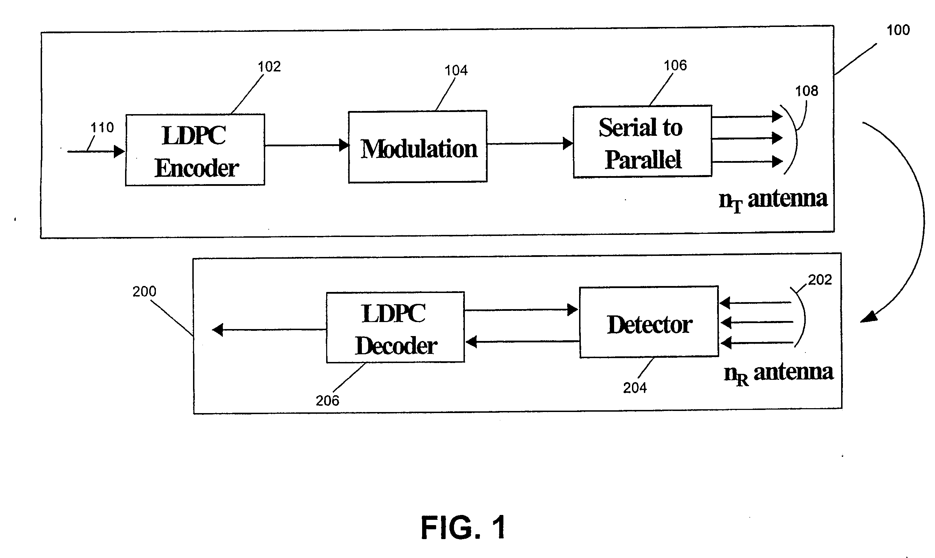

FIG. 1 illustrates a system block diagram of an LDPC-coded MIMO system of the present invention.

Transmitter 100 and receiver 200 are shown in a MIMO system. Within transmitter 100, there is an LDPC encoder 102, modulator 104, and a Serial-to-Parallel module 106, which feeds multiple antenna feeds 108. Within receiver 200, there are multiple antenna feeds 202, which are input to detector 204, which communicates with LDPC decoder 206. Additionally, orthogonal frequency division multiplexing and other circuitry can be inserted between modulator/detector and the channel without affecting the scope of the present invention.

For a MIMO system, the LDPC encoder 102 and LDPC decoder 206 of the present invention replace other FEC (e.g., turbo codes) generators. However, because of the potential complexity of LDPC codes, the present invention generates the LDPC codes in a specific way for use in a MIMO system.

In broadcast applications, such as MIMO systems, continuous mode receivers are widely used. Codes that perform well in low signal-to-noise (SNR) environments are at odds with these receivers 105 with respect to synchronization (e.g., carrier phase and carrier frequency). Many digital broadcast systems require use of additional training symbols beyond that of the normal overhead bits in a frame structure for their synchronization processes. The increase in overhead is particularly required when the Signal-to-Noise (SNR) is low; such an environment is typical when high performance codes are used in conjunction with high order modulation. Traditionally, continuous mode receivers utilize a feedback control loop to acquire and track carrier frequency and phase. Such approaches that are purely based on feedback control loops are prone to strong Radio Frequency (RF) phase noise and thermal noise, causing high cycle slip rates and an error floor on the overall receiver performance. Thus these approaches are burdened by increased overhead in terms of training symbols for certain performance target, in addition to limited acquisition range and long acquisition time. Further, these conventional synchronization techniques are dependent on the particular modulation scheme, thereby hindering flexibility in use of modulation schemes.

The LDPC or other FEC code or codes that are generated by the transmitter 100 facilitate high speed implementation without incurring any performance loss. These structured LDPC codes output from the transmitter 100 avoid assignment of a small number of check nodes to the bit nodes already vulnerable to channel errors by virtue of the modulation scheme (e.g., 8PSK). Such LDPC codes have a parallelizable decoding process, unlike turbo codes, which advantageously involves simple operations such as addition, comparison and table look-up. Moreover, carefully designed LDPC codes do not exhibit any sign of error floor, e.g., there is no decrease in errors even though the signal-to-noise ratio increases. If an error floor were to exist, it would be possible to use another code, such as a Bose/Chaudhuri/ Hocquenghem (BCH) code or other codes, to significantly suppress such error floor.

According to one embodiment of the present invention, the transmitter 100 generates, using a relatively simple encoding technique as explained herein below, LDPC codes based on parity check matrices which facilitate efficient memory access during decoding to communicate with receiver 200 in a MIMO system.

Transmitter 100 uses LDPC encoder 102 that accepts input 110 from an information source and outputs a coded information stream of higher redundancy suitable for error correction processing at the receiver 200. The information source generates k signals from a discrete alphabet, X. LDPC codes are specified with parity check matrices. Encoding LDPC codes requires, in general, specifying the generator matrices.

LDPC Encoder 203 generates signals using the input 110 and passes these signals to a modulator 205, using a simple encoding technique that makes use of only the parity check matrix by imposing structure onto the parity check matrix. Specifically, a restriction is placed on the parity check matrix by constraining certain portions of the matrix. Such a restriction results in negligible performance loss, and therefore, constitutes an attractive trade-off.

Transmission Schema

As shown in FIG. 1, there are $n_T$ transmit antennas 108 and $n_R$ receive antennas 202. The transmission for one channel is represented as $\mathbf{r} = \mathbf{A} \, \mathbf{s} + \mathbf{n}$, where
$\mathbf{s} = [s_1, s_2,...,s_{nT}]$ is the transmitted symbol vector,

$\mathbf{r} = [r_1, r_2,..., r_{nR}]$ is the received symbol vector $\qquad \mathbf{A} = \begin{bmatrix} a_{1,1} & a_{1,2} & ... & a_{1,n_T} \\ a_{2,1} & a_{2,2} & ... & a_{2,n_T} \\ \vdots & \vdots & \vdots & \vdots \\ a_{n_R,1} & a_{n_R,2} & ... & a_{n_R,n_T} \end{bmatrix}$ is the complex fade values matrix between each pair of
antennas, where $|a_{i,j}|$ is assumed Rayleigh distributed, and
$\mathbf{n}$ is the Average White Gaussian Noise (AWGN) noise vector.

For $\mathbf{A}$ matrices of subsequent channel uses, there are two extreme cases of interest, namely where $\mathbf{A}$ changes independently for each channel use (i.e. ideal interleaving), and where $\mathbf{A}$ is constant for the entire FEC frame (i.e. quasi-static fading).

The present invention applies specific LDPC codes for the MIMO channels described with the linear algebra described above. Maintaining high performance of the LDPC codes within the MIMO channels while maintaining an easy memory access feature of the subset of possible LDPC codes is an important feature of the code selection.

Design of the LDPC Codes and Constellation Bit Labelings

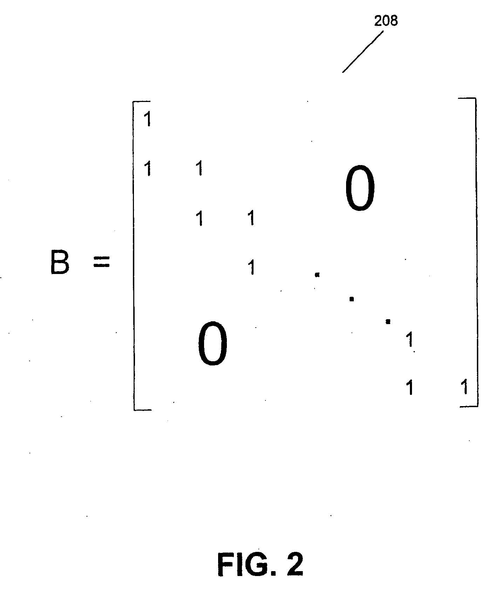

FIG. 2 illustrates a submatrix of the parity check matrix of the present invention.

The present invention restricts the parity check matrix of the LDPC codes as follows:

For a group of $M$ bit nodes, if the check nodes connected to the first bit node of degree, say $d_v$, are numbered as $a_1, a_2 ,..., a_{dv}$
then the check nodes connected to $i^{th}$ bit node ($i \leq M$) are numbered as,

$$\{a_1 + (i-1)q\} \bmod(N-K), \{a_2 + (i-1)q\} \bmod(N-K),....., \{a_{d_v} + (i-1)q\} \bmod(N-K)$$

where $N - K$ = total number of check nodes and $q = \dfrac{N - K}{M}$.

For the following groups of $M$ bit nodes, the check nodes connected to the first bit node of the group are in general randomly chosen so that at the end, all check nodes have the same degree, except for one check node with one less degree. Furthermore, the present invention includes a random search over these free constants $a_1, a_2,..., a_{dv}$, i.e., check nodes connected to the first bit node in every group of $M$ so that the resulting LDPC code has optimum performance on MIMO channels. Moreover the imposed structure on the parity check matrix 208 definition leads to efficient memory access.

In addition to the previous restriction, the parity check matrix is restricted to be of the form, $H_{(N-K)xN}$ = $[A_{(N-K)xK}B_{(N-K)x(N-K)}]$ where $B$ is staircase lower triangular as shown in FIG. 2, in other words only the $A = [a_{mn}]$ sub-matrix 208 is chosen according to the previous paragraph. From the structure of the $B$ sub-matrix 208, the first check node has one less degree than the others.

Further, the LDPC encoder 102 of the present invention systematically encodes an information block $i$ of size $k$, e.g., $i = (i_0, i_1,..., i_{k-1})$ onto a codeword $c$ of size $n$, e.g., $c= (i_0\ i_1,..., i_{k-1}\ p_0, p_1,... p_{n-k-1})$. The transmission of the codeword starts in the given order from $i_0$ and ends with $p_{n-k-1}$. The $n$ codeword bits are first mapped to $n / C$ constellation symbols where $2^C$ is the constellation size. The modulated symbols are then sent through $n_T$ transmit antennas in $n /$ ($C$ x $n_T$) channel use. LDPC code parameters $(n,k)$ are given in Table 1 for various code rates. The number of bit nodes with corresponding degrees are shown in Table 2.

The task of the encoder 102 is to determine $n-k$ parity bits $(p_0, p_1,..., p_{n-k-1})$ for every block of $k$ information bits, $(i_0, i_1 ,..., i_{k-1})$. A number of parallel engines are chosen, and each parallel engine accumulates information bits at specific parity bit addresses. For example, and not by way of limitation, 400 parallel engines can be chosen. A larger or smaller number of parallel engines can be chosen without departing from the scope of the present invention.

First, the parity bits are initialized to zero, i.e., $p_0 = p_1 = p_2 = ...= p_{n-k-1} = 0$.

Then, a first information bit, $i_0$, is accumulated at specific parity bit addresses, namely, at those parity bit addresses specified in the first row of Tables 4 through 6, with a code rate dependent offset for each increase in information bit. Other parity bit addresses and offsets can be used without departing from the scope of the present invention. For example, for rate 2/3 (Table 4), the accumulations are as follows:

$p_0 = p_0 \oplus i_0$, $p_{1531} = p_{1531} \oplus i_0$, $p_{876} = p_{876} \oplus i_0$, $p_{3403} = p_{3403} \oplus i_0$, $p_{1298} = p_{1298} \oplus i_0$,
$p_{3095} = p_{3085} \oplus i_0$, $p_{277} = p_{277} \oplus i_0$, $p_{2316} = p_{2316} \oplus i_0$, $p_{1180} = p_{1180} \oplus i_0$, $p_{2988} = p_{2988} \oplus i_0$,
$p_{3233} = p_{3233} \oplus i_0$, $p_{1851} = p_{1851} \oplus i_0$, and $p_{2127} = p_{2127} \oplus i_0$,

where all additions are in Generic Fast addition(2) (GF(2)) format.

Continuing with the present example, the accumulation for the next 399 information bits is done at $i_m, m=1,2,...$ 399 accumulate $i_m$ at parity bit addresses $\{x + m \bmod 400\ x\ q\} \bmod (n - k)$ where $x$ denotes the address of the parity bit accumulator corresponding to the first bit $i_0$, and $q$ is a code rate dependent offset constant specified in Table 3.

Continuing with the present example, $q =10$ for rate 2/3. So for example for information bit $i_1$, the accumulations take place at the offset parity bit matrix locations as follows:

$p_{10} = p_{10} \oplus i_1$, $p_{1541} = p_{1541} \oplus i_1$, $p_{886} = p_{886} \oplus i_1$, $p_{3413} = p_{3413} \oplus i_1$, $p_{1308} = p_{1308} \oplus i_1$,
$p_{3095} = p_{3095} \oplus i_1$, $p_{287} = p_{287} \oplus i_1$, $p_{2326} = p_{2326} \oplus i_1$, $p_{1190} = p_{1190} \oplus i_1$, $p_{2998} = p_{2998} \oplus i_1$,
$p_{3243} = p_{3243} \oplus i_1$, $p_{1861} = p_{1861} \oplus i_1$, and $p_{2137} = p_{2137} \oplus i_1$. Such accumulations then occur for the next 400 information bits as processed by the 400 parallel engines at the offset parity bit matrix locations.

As the first set of accumulations for each of the parallel engines complete, there will be additional information bits that need to be processed. In the example, there are 400 parallel engines, and when the 401st information bit is reached, accumulations must also occur.

For the 401st information bit, i.e., $i_{400}$, the present invention switches the location of where the accumulation takes place. The addresses of the parity bit accumulators for the next number of parallel engine calculations are given in the second row of Tables 4 through 7. In a similar manner the addresses of the parity bit accumulators for the following 399 information bits $i_m$, $m$ = 401,402,...,799 are obtained using the formula $\{x + m \bmod 400\ x\ q\} \bmod (n - k)$ where $x$ denotes the address of the parity bit accumulator corresponding to the information bit $i_{400}$, i.e. the entries in the second row of the Tables 4 through 7.

In a similar manner, for every group of 400 new information bits, a new row from Tables 4 through 7 are used to find the addresses of the parity bit accumulators. After all of the information bits are exhausted, the final parity bits are obtained as follows,

Sequentially perform the following operations starting with $i = 1$, i.e.,

$$p_i = p_i \oplus p_{i-1},$$

$i = 1,2,..., n - k - 1$, and the final content of $p_i$, $i = 0,1,.., n - k - 1$ is equal to the parity bit $p_i$.

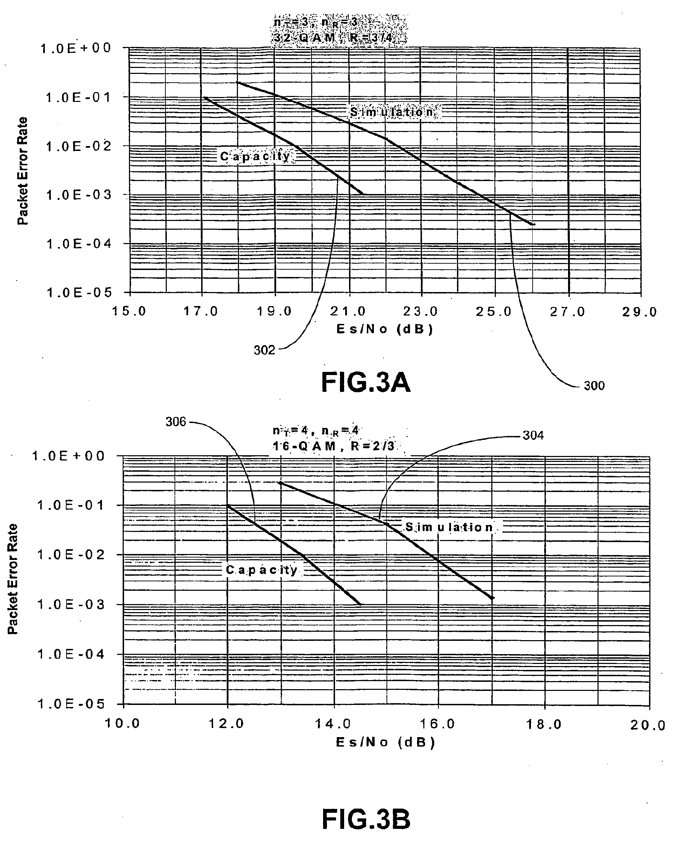

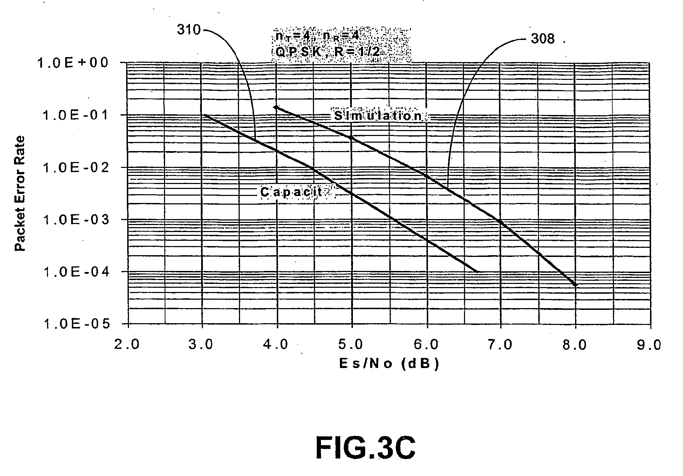

The LDPC encoded bits fill a two-dimensional interleaver matrix column by column. The matrix has 3 columns for 8-PSK modulation, 4 columns for 16-QAM modulation, 5 columns for 32-QAM modulation and 6 columns for 64-QAM modulation. Then each row of the matrix is mapped to a constellation symbol according to the bit labeling in Figure 3. With QPSK no interleaving is performed. The span of the interleaving is one LDPC frame length.

At the receiver, LDPC decoder and detector iterate soft information back and forth to improve the performance. A detector iteration is performed after every three LDPC decoder iteration.

Perfomance Results

FIGS. 3A-3C illustrate simulations of the performance of the present invention.

Performance results of the codes of the present invention are shown in FIGS. 3A-3B. FIG. 3A shows the simulated performance 300 of a quasi-static fading channel in a MIMO system having 3 transmit antennas and 3 receive antennas, using a 32-QAM code at rate 3/4, with Sharmon capacity 302 shown for comparison.

FIG. 3B shows the simulated performance 304 of a quasi-static fading channel in a MIMO system having 4 transmit antennas and 4 receive antennas, using a 64-QAM code at rate 2/3, with Shannon capacity 306 shown for comparison. FIG. 3C shows the simulated performance 308 of a quasi-static fading channel in a MIMO system having 4 transmit antennas and 4 receive antennas, using a QPSK code at rate 1/2, with Shannon capacity 310 shown for comparison.

The performance of the iterative LDPC decoder/MIMO detector of the present invention is approximately 1.5 dB away from the Shannon limit at FER=$10^{-2}$.

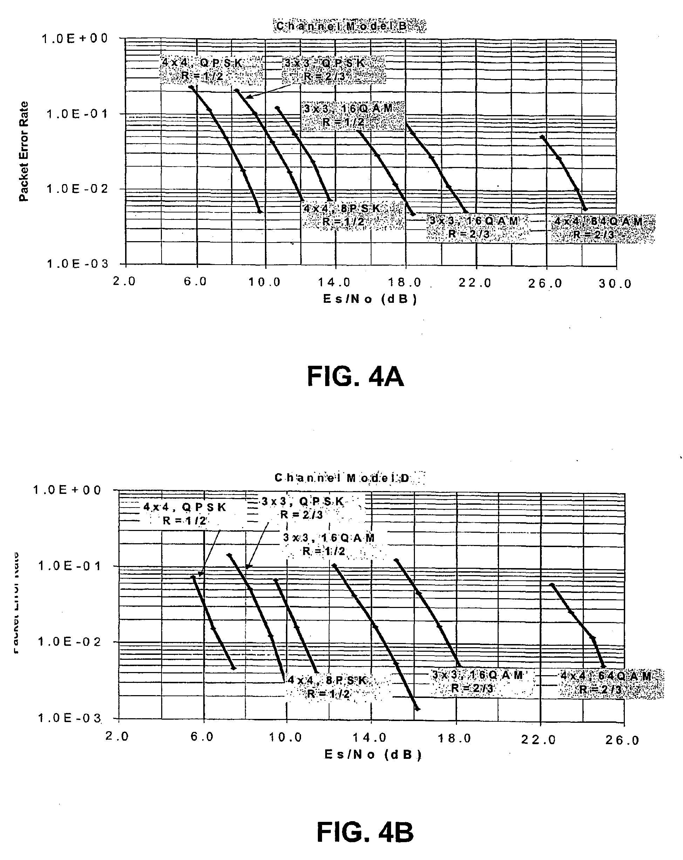

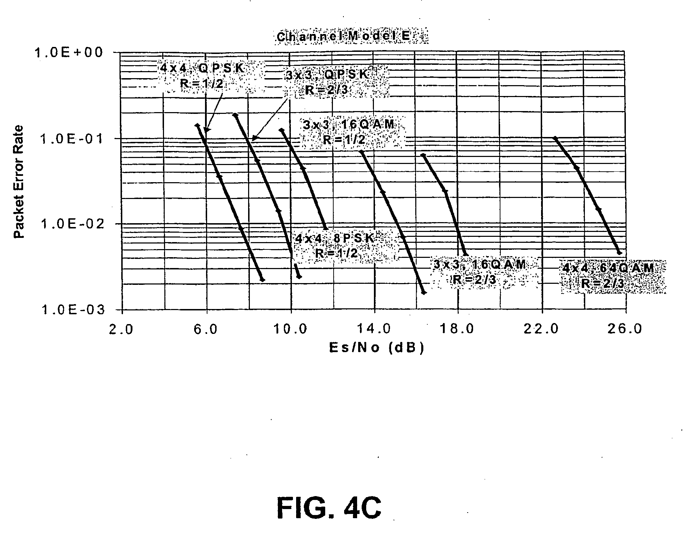

FIGS. 4A-4C illustrate simulations of the perfomance of short block length LDPC codes of the present invention.

For certain wireless LAN applications where the channel is very slowly fading, increasing the block length of codes generated by LDPC decoder 206 may not yield good enough performance to justify the extra complexity. In these scenarios, short block length LDPC codes with fully parallel decoding architecture may be preferable. Tables 8 and 9 (not forming part of the claimed invention) show the parity check matrices of two LDPC codes with rates 1/2 and 2/3. Code length in each case is N=192. The $i^{th}$ row in the tables gives the check nodes connected to the $i^{th}$ bit node.

Flowchart

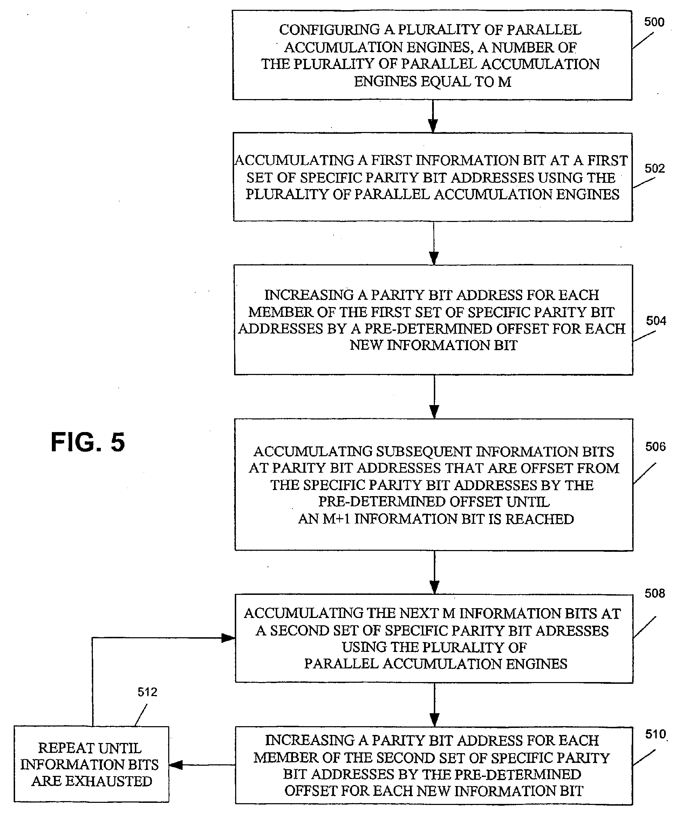

FIG. 5 is a flowchart illustrating a method in accordance with the present invention.

Box 500 illustrates performing configuring a plurality of parallel accumulation engines, a number of the plurality of parallel accumulation engines equal to M.

Box 502 illustrates performing accumulating a first information bit at a first set of specific parity bit addresses using the plurality of parallel accumulation engines.

Box 504 illustrates performing increasing a parity bit address for each member of the first set of specific parity bit addresses by a pre-determined offset for each new information bit.

Box 506 illustrates performing accumulating subsequent information bits at parity bit addresses that are offset from the specific parity bit addresses by a pre-determined offset until an M+1 information bit is reached.

Box 508 illustrates performing accumulating the next M information bits at a second set of specific parity bit addresses using the plurality of parallel accumulation engines.

Box 510 illustrates performing increasing a parity bit address for each member of the second set of specific parity bit addresses by the pro-determined offset for each new information bit. and

Box 512 illustrates performing repeating boxes 508 and 510 until the information bits are exhausted.

Conclusion

This concludes the description of the preferred embodiments of the present invention. The foregoing description of the preferred embodiment of the invention has been presented for the purposes of illustration and description. It is not intended to be exhaustive or to limit the invention to the precise form disclosed. Many modifications and variations are possible in light of the above teaching.

It is intended that the scope of the invention be limited not by this detailed description, but rather by the claims appended hereto and the equivalents thereof The above specification, examples and data provide a complete description of the manufacture and use of the composition of the invention. Since many embodiments of the invention can be made without departing from the scope of the invention, the invention resides in the claims hereinafter appended and the equivalents thereof.

**Table 1. LDPC Code Parameters (n,k)**

| Code Rate | LDPC Uncoded Block Length, k | LDPC Coded Block Length, n |
|---|---|---|
| 1/2 | 8000 | 16000 |
| 2/3 | 8000 | 12000 |
| 3/4 | 7200 | 9600 |
| 5/6 | 8000 | 9600 |

**Table 2. Number of Bit Nodes of Various Degrees**

| Code Rate | 13 | 12 | 8 | 3 | 2 | 1 |
|---|---|---|---|---|---|---|
| 1/2 | | | 4800 | 3200 | 7999 | 1 |
| 2/3 | 800 | | | 7200 | 3999 | 1 |
| 3/4 | | 800 | | 6400 | 2399 | 1 |
| 5/6 | 800 | | | 7200 | 1599 | 1 |

**Table 3. q Values**

| Code Rate | q |
|---|---|
| 2/3 | 10 |
| 1/2 | 20 |
| 3/4 | 6 |
| 5/6 | 4 |

**Table 4. Address of Parity Bit Accumulators (Rate 2/3)**

| | | | | | | | | | | | | |
|---|---|---|---|---|---|---|---|---|---|---|---|---|
| 0 | 1531 | 876 | 3403 | 1298 | 3085 | 277 | 2316 | 1180 | 2988 | 3233 | 1851 | 2127 |
| 1 | 2423 | 2843 | 1600 | 3571 | 3509 | 1732 | 794 | 2985 | 264 | 1366 | 2309 | 1932 |
| 2 | 1826 | 3364 | | | | | | | | | | |
| 3 | 1464 | 3371 | | | | | | | | | | |
| 4 | 3055 | 3767 | | | | | | | | | | |
| 5 | 649 | 2172 | | | | | | | | | | |
| 6 | 2607 | 2095 | | | | | | | | | | |
| 7 | 1842 | 559 | | | | | | | | | | |
| 8 | 1630 | 3150 | | | | | | | | | | |
| 9 | 1608 | 3558 | | | | | | | | | | |
| 0 | 526 | 2323 | | | | | | | | | | |
| 1 | 505 | 2305 | | | | | | | | | | |
| 2 | 2317 | 2594 | | | | | | | | | | |
| 3 | 3684 | 171 | | | | | | | | | | |
| 4 | 3831 | 2296 | | | | | | | | | | |
| 5 | 753 | 1878 | | | | | | | | | | |
| 6 | 3908 | 1737 | | | | | | | | | | |
| 7 | 1132 | 2962 | | | | | | | | | | |

(continued)

| 8 | 2340 | 1550 |
|---|------|------|
| 9 | 2519 | 1769 |

**Table 5. Address of Parity Bit Accumulators (Rate 1/2)**

| 12 | 922 | 3230 | 286 | 6581 | 3068 | 2393 | 2290 |
|----|------|------|------|------|------|------|------|
| 13 | 1749 | 4368 | 7492 | 6487 | 354 | 4807 | 1829 |
| 14 | 5381 | 4074 | 4464 | 7568 | 1651 | 2664 | 5158 |
| 15 | 7823 | 4362 | 7543 | 6671 | 7320 | 2292 | 3696 |
| 16 | 5734 | 6843 | 6457 | 2774 | 1665 | 4823 | 1917 |
| 17 | 958 | 4478 | 4582 | 5620 | 6266 | 1796 | 1150 |
| 18 | 1730 | 7085 | 7145 | 6355 | 6101 | 5839 | 6442 |
| 19 | 4572 | 1780 | 1133 | 4219 | 5778 | 1055 | 5529 |
| 0 | 3597 | 6167 | | | | | |
| 1 | 2544 | 53 | | | | | |
| 2 | 5955 | 169 | | | | | |
| 3 | 3051 | 1026 | | | | | |
| 4 | 3420 | 3917 | | | | | |
| 5 | 5559 | 272 | | | | | |
| 6 | 1313 | 3599 | | | | | |
| 7 | 6956 | 1991 | | | | | |
| 8 | 4105 | 2744 | | | | | |
| 9 | 4106 | 7001 | | | | | |
| 10 | 3467 | 6115 | | | | | |
| 11 | 7948 | 4436 | | | | | |

**Table 6. Address of Parity Bit Accumulators (Rate 3/4)**

| 0 | 1071 | 1268 | 595 | 804 | 1947 | 1564 | 713 | 1736 | 1618 | 2281 | 317 |
|---|------|------|------|------|------|------|------|------|------|------|------|
| 1 | 1382 | 275 | 1763 | 452 | 2254 | 675 | 1105 | 1266 | 1824 | 1161 | 1586 |
| 2 | 617 | 840 | | | | | | | | | |
| 3 | 144 | 2101 | | | | | | | | | |
| 4 | 2293 | 874 | | | | | | | | | |
| 5 | 2104 | 2211 | | | | | | | | | |
| 0 | 802 | 368 | | | | | | | | | |
| 1 | 1873 | 202 | | | | | | | | | |
| 2 | 261 | 1925 | | | | | | | | | |
| 3 | 1806 | 711 | | | | | | | | | |
| 4 | 314 | 2214 | | | | | | | | | |
| 5 | 1265 | 139 | | | | | | | | | |
| 0 | 316 | 732 | | | | | | | | | |
| 1 | 291 | 1930 | | | | | | | | | |
| 2 | 942 | 1067 | | | | | | | | | |
| 3 | 1333 | 121 | | | | | | | | | |
| 4 | 698 | 2270 | | | | | | | | | |
| 5 | 1127 | 1197 | | | | | | | | | |

**Table 7. Address of Parity Bit Accumulators (Rate 5/6)**

| 0 | 1265 | 699 | 614 | 1408 | 156 | 521 | 228 | 339 | 1539 | 1352 | 991 | 1125 |
|---|------|------|------|------|------|------|------|------|------|------|------|------|
| 1 | 543 | 198 | 1211 | 465 | 1063 | 638 | 826 | 965 | 121 | 1342 | 396 | 690 |

(continued)

| 2 | 770 | 212 |
|---|-----|-----|
| 3 | 252 | 557 |
| 0 | 576 | 1529 |
| 1 | 586 | 860 |
| 2 | 2809 | 1079 |
| 3 | 1419 | 1114 |
| 0 | 1110 | 1399 |
| 1 | 665 | 148 |
| 2 | 615 | 926 |
| 3 | 356 | 1341 |
| 0 | 349 | 567 |
| 1 | 1192 | 901 |
| 2 | 1011 | 778 |
| 3 | 418 | 888 |
| 0 | 381 | 1478 |
| 1 | 1246 | 175 |
| 2 | 163 | 1284 |
| 3 | 480 | 1321 |

**Table 8: Parity Check Matrix of R=1/2 LDPC code (N=192)**

| 20 | 33 | 77 |
|----|----|----|
| 17 | 83 | 48 |
| 89 | 4 | 92 |
| 58 | 82 | 27 |
| 32 | 26 | 67 |
| 86 | 40 | 24 |
| 24 | 0 | 33 |
| 58 | 23 | 84 |
| 64 | 5 | 62 |
| 81 | 40 | 60 |
| 59 | 9 | 82 |
| 53 | 82 | 54 |
| 29 | 59 | 79 |
| 46 | 54 | 45 |
| 91 | 78 | 28 |
| 90 | 58 | 87 |
| 5 | 35 | 34 |
| 68 | 45 | 37 |
| 31 | 38 | 63 |
| 83 | 55 | 84 |
| 16 | 30 | 75 |
| 89 | 77 | 48 |
| 6 | 3 | 65 |
| 70 | 8 | 87 |
| 90 | 41 | 29 |
| 17 | 56 | 95 |
| 52 | 34 | 21 |
| 86 | 60 | 0 |
| 3 | 38 | 93 |
| 28 | 61 | 55 |

(continued)

| | | |
|---|---|---|
| 12 | 70 | 19 |
| 5 | 36 | 92 |
| 73 | 72 | 56 |
| 36 | 47 | 64 |
| 78 | 8 | 2 |
| 83 | 76 | 85 |
| 43 | 85 | 24 |
| 70 | 23 | 27 |
| 2 | 15 | 67 |
| 1 | 91 | 39 |
| 38 | 71 | 20 |
| 28 | 67 | 80 |
| 9 | 49 | 32 |
| 36 | 8 | 50 |
| 44 | 19 | 94 |
| 4 | 1 | 50 |
| 75 | 10 | 7 |
| 51 | 49 | 25 |
| 13 | 81 | 88 |
| 34 | 50 | 25 |
| 11 | 10 | 57 |
| 69 | 75 | 95 |
| 44 | 57 | 91 |
| 16 | 74 | 26 |
| 89 | 32 | 62 |
| 80 | 6 | 61 |
| 63 | 73 | 79 |
| 72 | 39 | 0 |
| 21 | 61 | 15 |
| 85 | 88 | 94 |
| 11 | 20 | 87 |
| 18 | 53 | 56 |
| 93 | 90 | 80 |
| 35 | 37 | 44 |
| 2 | 31 | 27 |
| 41 | 59 | 40 |
| 55 | 46 | 78 |
| 42 | 88 | 22 |
| 69 | 71 | 51 |
| 31 | 76 | 46 |
| 51 | 84 | 7 |
| 12 | 37 | 64 |
| 73 | 17 | 43 |
| 35 | 79 | 68 |
| 7 | 11 | 93 |
| 62 | 60 | 52 |
| 18 | 21 | 65 |
| 43 | 66 | 47 |
| 1 | 41 | 74 |
| 42 | 16 | 48 |
| 14 | 76 | 10 |

(continued)

| | | |
|---|---|---|
| 42 | 52 | 77 |
| 47 | 30 | 63 |
| 29 | 30 | 69 |
| 6 | 4 | 25 |
| 9 | 94 | 3 |
| 66 | 49 | 71 |
| 39 | 45 | 95 |
| 86 | 12 | 22 |
| 19 | 18 | 74 |
| 22 | 26 | 13 |
| 14 | 13 | 23 |
| 68 | 54 | 81 |
| 15 | 33 | 72 |
| 66 | 14 | 53 |
| 65 | 92 | 57 |
| 0 | 1 | |
| 1 | 2 | |
| 2 | 3 | |
| 3 | 4 | |
| 4 | 5 | |
| 5 | 6 | |
| 6 | 7 | |
| 7 | 8 | |
| 8 | 9 | |
| 9 | 10 | |
| 10 | 11 | |
| 11 | 12 | |
| 12 | 13 | |
| 13 | 14 | |
| 14 | 15 | |
| 15 | 16 | |
| 16 | 17 | |
| 17 | 18 | |
| 18 | 19 | |
| 19 | 20 | |
| 20 | 21 | |
| 21 | 22 | |
| 22 | 23 | |
| 23 | 24 | |
| 24 | 25 | |
| 25 | 26 | |
| 26 | 27 | |
| 27 | 28 | |
| 28 | 29 | |
| 29 | 30 | |
| 30 | 31 | |
| 31 | 32 | |
| 32 | 33 | |
| 33 | 34 | |
| 34 | 35 | |
| 35 | 36 | |

(continued)

| | |
|---|---|
| 36 | 37 |
| 37 | 38 |
| 38 | 39 |
| 39 | 40 |
| 40 | 41 |
| 41 | 42 |
| 42 | 43 |
| 43 | 44 |
| 44 | 45 |
| 45 | 46 |
| 46 | 47 |
| 47 | 48 |
| 48 | 49 |
| 49 | 50 |
| 50 | 51 |
| 51 | 52 |
| 52 | 53 |
| 53 | 54 |
| 54 | 55 |
| 55 | 56 |
| 56 | 57 |
| 57 | 58 |
| 58 | 59 |
| 59 | 60 |
| 60 | 61 |
| 61 | 62 |
| 62 | 63 |
| 63 | 64 |
| 64 | 65 |
| 65 | 66 |
| 66 | 67 |
| 67 | 68 |
| 68 | 69 |
| 69 | 70 |
| 70 | 71 |
| 71 | 72 |
| 72 | 73 |
| 73 | 74 |
| 74 | 75 |
| 75 | 76 |
| 76 | 77 |
| 77 | 78 |
| 78 | 79 |
| 79 | 80 |
| 80 | 81 |
| 81 | 82 |
| 82 | 83 |
| 83 | 84 |
| 84 | 85 |
| 85 | 86 |
| 86 | 87 |

(continued)

| | |
|---|---|
| 87 | 88 |
| 88 | 89 |
| 89 | 90 |
| 90 | 91 |
| 91 | 92 |
| 92 | 93 |
| 93 | 94 |
| 94 | 95 |
| 95 | |

**Table 9: Parity Check Matrix of R=2/3 LDPC code (N=192)**

| | | |
|---|---|---|
| 18 | 22 | 51 |
| 11 | 55 | 32 |
| 59 | 3 | 61 |
| 38 | 54 | 18 |
| 21 | 17 | 45 |
| 57 | 26 | 16 |
| 16 | 0 | 21 |
| 39 | 15 | 56 |
| 43 | 3 | 41 |
| 54 | 27 | 40 |
| 39 | 6 | 55 |
| 35 | 55 | 36 |
| 19 | 39 | 52 |
| 31 | 36 | 30 |
| 61 | 52 | 60 |
| 39 | 58 | 3 |
| 23 | 22 | 45 |
| 30 | 25 | 20 |
| 25 | 42 | 55 |
| 37 | 56 | 11 |
| 20 | 50 | 59 |
| 52 | 32 | 4 |
| 2 | 43 | 47 |
| 5 | 57 | 60 |
| 27 | 20 | 11 |
| 38 | 63 | 35 |
| 23 | 15 | 57 |
| 40 | 0 | 2 |
| 25 | 62 | 19 |
| 41 | 37 | 8 |
| 47 | 13 | 3 |
| 24 | 61 | 49 |
| 48 | 37 | 24 |
| 31 | 42 | 52 |
| 5 | 1 | 56 |
| 51 | 57 | 29 |
| 57 | 17 | 47 |
| 16 | 19 | 1 |
| 5 | 10 | 45 |

(continued)

| | | |
|---|---|---|
| 1 | 61 | 26 |
| 25 | 48 | 14 |
| 19 | 45 | 54 |
| 6 | 32 | 22 |
| 24 | 5 | 33 |
| 29 | 14 | 62 |
| 2 | 1 | 34 |
| 50 | 6 | 4 |
| 34 | 33 | 17 |
| 8 | 55 | 58 |
| 23 | 33 | 16 |
| 7 | 6 | 37 |
| 46 | 50 | 63 |
| 29 | 38 | 60 |
| 11 | 50 | 18 |
| 60 | 22 | 41 |
| 54 | 4 | 41 |
| 42 | 49 | 53 |
| 49 | 26 | 0 |
| 14 | 41 | 10 |
| 56 | 59 | 63 |
| 7 | 13 | 58 |
| 12 | 37 | 39 |
| 62 | 60 | 56 |
| 23 | 24 | 30 |
| 0 | 19 | 27 |
| 40 | 26 | 38 |
| 31 | 54 | 28 |
| 59 | 15 | 47 |
| 48 | 35 | 23 |
| 53 | 31 | 34 |
| 58 | 5 | 26 |
| 31 | 43 | 50 |
| 12 | 29 | 25 |
| 54 | 47 | 7 |
| 62 | 43 | 36 |
| 13 | 15 | 44 |
| 30 | 44 | 34 |
| 0 | 28 | 51 |
| 29 | 13 | 33 |
| 11 | 10 | 51 |
| 7 | 29 | 35 |
| 52 | 27 | 41 |
| 25 | 27 | 47 |
| 4 | 21 | 21 |
| 4 | 61 | 44 |
| 32 | 46 | 30 |
| 32 | 63 | 58 |
| 2 | 18 | 15 |
| 14 | 53 | 16 |
| 22 | 9 | 4 |

(continued)

| | | |
|---|---|---|
| 10 | 43 | 21 |
| 53 | 12 | 45 |
| 48 | 7 | 10 |
| 34 | 59 | 8 |
| 3 | 40 | 1 |
| 9 | 55 | 17 |
| 46 | 31 | 59 |
| 9 | 16 | 18 |
| 35 | 34 | 51 |
| 15 | 28 | 48 |
| 53 | 3 | 37 |
| 8 | 19 | 24 |
| 33 | 44 | 42 |
| 20 | 1 | 12 |
| 26 | 24 | 32 |
| 42 | 18 | 12 |
| 26 | 43 | 20 |
| 49 | 28 | 9 |
| 35 | 44 | 46 |
| 9 | 61 | 40 |
| 14 | 50 | 39 |
| 49 | 17 | 14 |
| 12 | 6 | 36 |
| 7 | 20 | 21 |
| 11 | 28 | 62 |
| 8 | 6 | 48 |
| 53 | 63 | 36 |
| 62 | 46 | 0 |
| 13 | 38 | 5 |
| 51 | 49 | 8 |
| 28 | 44 | 63 |
| 46 | 2 | 10 |
| 60 | 23 | 42 |
| 18 | 17 | 30 |
| 38 | 9 | 58 |
| 21 | 56 | 52 |
| 22 | 27 | 57 |
| 33 | 45 | 40 |
| 0 | 1 | |
| 1 | 2 | |
| 2 | 3 | |
| 3 | 4 | |
| 4 | 5 | |
| 5 | 6 | |
| 6 | 7 | |
| 7 | 8 | |
| 8 | 9 | |
| 9 | 10 | |
| 10 | 11 | |
| 11 | 12 | |
| 12 | 13 | |

(continued)

| | |
|---|---|
| 13 | 14 |
| 14 | 15 |
| 15 | 16 |
| 16 | 17 |
| 17 | 18 |
| 18 | 19 |
| 19 | 20 |
| 20 | 21 |
| 21 | 22 |
| 22 | 23 |
| 23 | 24 |
| 24 | 25 |
| 25 | 26 |
| 26 | 27 |
| 27 | 28 |
| 28 | 29 |
| 29 | 30 |
| 30 | 31 |
| 31 | 32 |
| 32 | 33 |
| 33 | 34 |
| 34 | 35 |
| 35 | 36 |
| 36 | 37 |
| 37 | 38 |
| 38 | 39 |
| 39 | 40 |
| 40 | 41 |
| 41 | 42 |
| 42 | 43 |
| 43 | 44 |
| 44 | 45 |
| 45 | 46 |
| 46 | 47 |
| 47 | 48 |
| 48 | 49 |
| 49 | 50 |
| 50 | 51 |
| 51 | 52 |
| 52 | 53 |
| 53 | 54 |
| 54 | 55 |
| 55 | 56 |
| 56 | 57 |
| 57 | 58 |
| 58 | 59 |
| 59 | 60 |
| 60 | 61 |
| 61 | 62 |
| 62 | 63 |
| 63 | |

**Claims**

1. A Low Density Parity Check (LDPC) coder (102) used to encode data comprising a plurality of information bits in broadcast systems, comprising:

a plurality of parallel accumulation engines,
wherein there is a number, $M$, of the plurality of parallel accumulation engines,
wherein $M$ is equal to 400,
wherein:

information bits are accumulated in the plurality of parallel accumulation engines according to a parity bit check matrix restricted to a form $H_{(N-K)xN} = [A_{(N-K)xK} B_{(N-K)r(N-K)}]$ where $B$ is staircase lower triangular;
a first information bit of a first group of $M$ information bits in the plurality of information bits is accumulated at a first set of specific parity bit addresses, specified by the first row in a given table of Tables 1- 4 below corresponding to a particular code rate, in the plurality of parallel accumulation engines;
the parity bit address in the encoder for each member of the first set of specific parity bit addresses is increased by a pre-determined offset according to $\{x + m$ mod $400$ x $q\}$ mod $(N- K)$ for each subsequent information bit, $i_m$, after the first information bit in the first group of $M$ information bits, wherein x denotes the parity bit addresses used for the first information bit specified by the first row in the given table;
each of the subsequent information bits in the first group of $M$ information bits is accumulated at parity bit addresses that are offset from the specific parity bit addresses by the pre-determined offset until an $M+1$ information bit is reached;
a next subsequent group of $M$ information bits in the plurality of information bits are accumulated at a further set of specific parity bit addresses specified by all values in the next subsequent row in the given table according to $\{x + m$ mod $400$ x $q\}$ mod $(N - K)$, using the plurality of parallel accumulation engines, wherein the parity bit address for each member of the further set of specific parity bit addresses is increased by the pre-determined offset according to $\{x + m$ mod $400$ x $q\}$ mod $(N- K)$ for each new information bit, wherein x denotes the parity bit addresses used for the first information bit in the next subsequent group of $M$ information bits specified by the next subsequent row in the given table;
each information bit in successive subsequent groups of $M$ information bits is accumulated using additional sets of specific parity bit addresses and pre-determined offsets calculated in the same way as for the further set of specific parity bit addresses at successive subsequent rows of the given table until all information bits in the plurality of information bits are accumulated;
final parity bits are obtained according to $p_j = p_j \oplus p_{j-1}$, for $j = 1... N-K-1$ wherein the final content of each parity bit address is equal to the parity bit, $p_j$;
$K$ is a size of an information block and $N$ is a size of a codeword; and
$q$ equates to $(N- K)/M$.

**Table 1. Address of Parity Bit Accumulators (Rate 2/3, q = 10, K = 8000)**

| | | | | | | | | | | | | |
|---|---|---|---|---|---|---|---|---|---|---|---|---|
| 0 | 1531 | 876 | 3403 | 1298 | 3085 | 277 | 2316 | 1180 | 2988 | 3233 | 1851 | 2127 |
| 1 | 2423 | 2843 | 1600 | 3571 | 3509 | 1732 | 794 | 2985 | 264 | 1366 | 2309 | 1932 |
| 2 | 1826 | 3364 | | | | | | | | | | |
| 3 | 1464 | 3371 | | | | | | | | | | |
| 4 | 3055 | 3767 | | | | | | | | | | |
| 5 | 649 | 2172 | | | | | | | | | | |
| 6 | 2607 | 2095 | | | | | | | | | | |
| 7 | 1842 | 559 | | | | | | | | | | |
| 8 | 1630 | 3150 | | | | | | | | | | |
| 9 | 1608 | 3558 | | | | | | | | | | |
| 0 | 526 | 2323 | | | | | | | | | | |
| 1 | 505 | 2305 | | | | | | | | | | |
| 2 | 2317 | 2594 | | | | | | | | | | |
| 3 | 3684 | 171 | | | | | | | | | | |
| 4 | 3831 | 2296 | | | | | | | | | | |
| 5 | 753 | 1878 | | | | | | | | | | |
| 3 | 3908 | 1737 | | | | | | | | | | |

(continued)

| 7 | 1132 | 2962 |
|---|------|------|
| 8 | 2340 | 1550 |
| 9 | 2519 | 1769 |

**Table 2. Address of Parity Bit Accumulators (Rate 1/2, q = 20, K = 8000)**

| 12 | 922 | 3230 | 286 | 6581 | 3068 | 2393 | 2290 |
|----|-----|------|-----|------|------|------|------|
| 13 | 1749 | 4368 | 7492 | 6487 | 354 | 4807 | 1829 |
| 14 | 5381 | 4074 | 4464 | 7568 | 1651 | 2664 | 5158 |
| 15 | 7823 | 4362 | 7543 | 6671 | 7320 | 2292 | 3696 |
| 16 | 5734 | 6843 | 6457 | 2774 | 1665 | 4823 | 1917 |
| 17 | 958 | 4478 | 4582 | 5620 | 6266 | 1796 | 1150 |
| 18 | 1730 | 7085 | 7145 | 6355 | 6101 | 5839 | 6442 |
| 19 | 4572 | 1780 | 1133 | 4219 | 5778 | 1055 | 5529 |
| 0 | 3597 | 6167 | | | | | |
| 1 | 2544 | 53 | | | | | |
| 2 | 5955 | 169 | | | | | |
| 3 | 3051 | 1026 | | | | | |
| 4 | 3420 | 3917 | | | | | |
| 5 | 5259 | 272 | | | | | |
| 6 | 1313 | 3599 | | | | | |
| 7 | 6956 | 1991 | | | | | |
| 8 | 4105 | 2744 | | | | | |
| 9 | 4106 | 7001 | | | | | |
| 10 | 3467 | 6115 | | | | | |
| 11 | 7948 | 4436 | | | | | |

**Table 3. Address of Parity Bit Accumulators (Rate 3/4, q = 6, K = 7200)**

| 0 | 1071 | 1268 | 595 | 804 | 1947 | 1564 | 713 | 1736 | 1618 | 2281 | 317 |
|---|------|------|-----|-----|------|------|-----|------|------|------|-----|
| 1 | 1382 | 275 | 1763 | 452 | 2254 | 675 | 1105 | 1266 | 1824 | 1161 | 1586 |
| 2 | 617 | 840 | | | | | | | | | |
| 3 | 144 | 2101 | | | | | | | | | |
| 4 | 2293 | 874 | | | | | | | | | |
| 5 | 2104 | 2211 | | | | | | | | | |
| 0 | 802 | 368 | | | | | | | | | |
| 1 | 1873 | 202 | | | | | | | | | |
| 2 | 261 | 1925 | | | | | | | | | |
| 3 | 1806 | 711 | | | | | | | | | |
| 4 | 314 | 2214 | | | | | | | | | |
| 5 | 1265 | 139 | | | | | | | | | |
| 0 | 316 | 732 | | | | | | | | | |
| 1 | 291 | 1930 | | | | | | | | | |
| 2 | 942 | 1067 | | | | | | | | | |
| 3 | 1333 | 121 | | | | | | | | | |
| 4 | 698 | 2270 | | | | | | | | | |
| 5 | 1127 | 1197 | | | | | | | | | |

**Table 4. Address of Parity Bit Accumulators (Rate 5/6, q = 4, K = 8000)**

| | | | | | | | | | | | | |
|---|---|---|---|---|---|---|---|---|---|---|---|---|
| 0 | 1265 | 699 | 614 | 1408 | 156 | 521 | 228 | 339 | 1539 | 1352 | 991 | 1125 |
| 1 | 543 | 198 | 1211 | 465 | 1063 | 638 | 826 | 965 | 121 | 1342 | 396 | 690 |
| 2 | 770 | 212 | | | | | | | | | | |
| 3 | 252 | 557 | | | | | | | | | | |
| 0 | 576 | 529 | | | | | | | | | | |
| 1 | 586 | 860 | | | | | | | | | | |
| 2 | 809 | 1079 | | | | | | | | | | |
| 3 | 1419 | 1114 | | | | | | | | | | |
| 0 | 1110 | 1399 | | | | | | | | | | |
| 1 | 665 | 148 | | | | | | | | | | |
| 2 | 615 | 926 | | | | | | | | | | |
| 3 | 356 | 1341 | | | | | | | | | | |
| 0 | 349 | 567 | | | | | | | | | | |
| 1 | 1192 | 901 | | | | | | | | | | |
| 2 | 1011 | 778 | | | | | | | | | | |
| 3 | 418 | 888 | | | | | | | | | | |
| 0 | 381 | 1478 | | | | | | | | | | |
| 1 | 1246 | 175 | | | | | | | | | | |
| 2 | 163 | 1284 | | | | | | | | | | |
| 3 | 480 | 1321 | | | | | | | | | | |

2. The system of claim 1, wherein the LDPC codes are used in a Multiple-Input, Multiple-Output (MIMO) system.

3. The system of claim 2, further comprising accumulating the parity bits by adding each parity bit content to the immediately preceding parity bit content.

4. A method for encoding data comprising a plurality of information bits using Low Density Parity Check (LDPC) codes, comprising:

a) accumulating, with an encoder, a first group of $M$ information bits in the plurality of information bits using a plurality of $M$ parallel accumulation engines at a first set of specific parity bit addresses, specified by the first row in a given table of Tables 1 - 4 below corresponding to a particular code rate, in the plurality of parallel accumulation engines, wherein accumulation is according to a parity check matrix of the form $H_{(N-K) \times N} = [A_{(N-K) \times K} \, B_{(N-K) \times (N-K)}]$ where $B$ is staircase lower triangular, and wherein M = 400;

b) increasing the parity bit address in the encoder for each member of the first set of specific parity bit addresses by a pre-determined offset according to $\{x + m \bmod 400 \times q\} \bmod (N\text{-}K)$ for each subsequent information bit, $i_m$, after the first information bit in the first group of $M$ information bits, wherein $x$ denotes the parity bit addresses used for the first information bit specified by the first row in the given table;

c) accumulating each of the subsequent information bits in the first group of M information bits at parity bit addresses that are offset from the specific parity bit addresses by the pre-determined offset until an $M+1$ information bit is reached;

d) accumulating a next subsequent group of $M$ information bits in the plurality of information bits at a further set of specific parity bit addresses specified by all values in the next subsequent row in the given table according to $\{x + m \bmod 400 \times q\} \bmod (N\text{-}K)$, using the plurality of parallel accumulation engines, wherein the parity bit address for each member of the further set of specific parity bit addresses is increased by the pre-determined offset according to $\{x + m \bmod 400 \times q\} \bmod (N\text{-}K)$ for each new information bit, wherein $x$ denotes the parity bit addresses used for the first information bit in the next subsequent group of M information bits specified by the next subsequent row in the given table; and

e) accumulating each information bit in successive subsequent groups of M information bits using additional sets of specific parity bit addresses and pre-determined offsets calculated in the same way as for step d) at successive subsequent rows of the given table until all information bits in the plurality of information bits are accumulated,

f) final parity bits are obtained according to $p_j = p_j \oplus p_{j-1}$, for $j = 1...N\text{-}K\text{-}1$ wherein the final content of each parity bit address is equal to the parity bit $p_i$.

g) *K* is a size of an information block and *N* is a size of a codeword; and q equates to *(N-K)/M.*

**Tables 1. Address of Parity Bit Accumulators (Rate 2/3, q =10, K = 8000)**

| | | | | | | | | | | | | | |
|---|---|---|---|---|---|---|---|---|---|---|---|---|---|
| 0 | 1531 | 876 | | 3403 | 1298 | 3085 | 277 | 2316 | 1180 | 2988 | 3233 | 1851 | 2127 |
| 1 | 2423 | | 2843 | 1600 | 3571 | 3509 | 1732 | 794 | 2985 | 264 | 1366 | 2309 | 1932 |
| 2 | 1826 | | 3364 | | | | | | | | | | |
| 3 | 1464 | | 3371 | | | | | | | | | | |
| 4 | 3055 | | 3767 | | | | | | | | | | |
| 5 | 649 | | 2172 | | | | | | | | | | |
| 6 | 2607 | | 2095 | | | | | | | | | | |
| 7 | 1842 | | 559 | | | | | | | | | | |
| 8 | 1630 | | 3150 | | | | | | | | | | |
| 9 | 1608 | | 3558 | | | | | | | | | | |
| 0 | 526 | | 2323 | | | | | | | | | | |
| 1 | 505 | | 2305 | | | | | | | | | | |
| 2 | 2317 | | 2594 | | | | | | | | | | |
| 3 | 3684 | | 171 | | | | | | | | | | |
| 4 | 3831 | | 2296 | | | | | | | | | | |
| 5 | 753 | | 1878 | | | | | | | | | | |
| 6 | 3908 | | 1737 | | | | | | | | | | |
| 7 | 1132 | | 2962 | | | | | | | | | | |
| 8 | 2340 | | 1550 | | | | | | | | | | |
| 9 | 2519 | | 1769 | | | | | | | | | | |

**Table 2. Address of Parity Bit Accumulators (Rate 1/2, q = 20, K = 8000)**

| | | | | | | | |
|---|---|---|---|---|---|---|---|
| 12 | 922 | 3230 | 286 | 6581 | 3068 | 2393 | 2290 |
| 13 | 1749 | 4368 | 7492 | 6487 | 354 | 4807 | 1829 |
| 14 | 5381 | 4074 | 4464 | 7568 | 1651 | 2664 | 5158 |
| 15 | 7823 | 4362 | 7543 | 6671 | 7320 | 2292 | 3696 |
| 16 | 5734 | 6843 | 6457 | 2774 | 1665 | 4823 | 1917 |
| 17 | 958 | 4478 | 4582 | 5620 | 6266 | 1796 | 1150 |
| 18 | 1730 | 7085 | 7145 | 6355 | 6101 | 5839 | 6442 |
| 19 | 4572 | 1780 | 1133 | 4219 | 5778 | 1055 | 5529 |
| 0 | 3597 | 6167 | | | | | |
| 1 | 2544 | 53 | | | | | |
| 2 | 5955 | 169 | | | | | |
| 3 | 3051 | 1026 | | | | | |
| 4 | 3420 | 3917 | | | | | |
| 5 | 5259 | 272 | | | | | |
| 6 | 1313 | 3599 | | | | | |
| 7 | 6956 | 1991 | | | | | |
| 8 | 4105 | 2744 | | | | | |
| 9 | 4106 | 7001 | | | | | |
| 10 | 3467 | 6115 | | | | | |
| 11 | 7948 | 4436 | | | | | |

**Table 3, Address of Parity Bit Accumulators (Rate 3/4, q=6, K = 7200)**

| | | | | | | | | | | | |
|---|---|---|---|---|---|---|---|---|---|---|---|
| 0 | 1071 | 1268 | 595 | 804 | 1947 | 1564 | 713 | 1736 | 1618 | 2281 | 317 |
| 1 | 1382 | 275 | 1763 | 452 | 2254 | 675 | 1105 | 1266 | 1824 | 1161 | 1586 |
| 2 | 617 | 840 | | | | | | | | | |

(continued)

| | | |
|---|---|---|
| 3 | 144 | 2101 |
| 4 | 2293 | 874 |
| 5 | 2104 | 2211 |
| 0 | 802 | 368 |
| 1 | 1873 | 202 |
| 2 | 261 | 1925 |
| 3 | 1806 | 711 |
| 4 | 314 | 2214 |
| 5 | 1265 | 139 |
| 0 | 316 | 732 |
| 1 | 291 | 1930 |
| 2 | 942 | 1067 |
| 3 | 1333 | 121 |
| 4 | 698 | 2270 |
| 5 | 1127 | 1197 |

**Table 4. Address of Parity Bit Accumulators (Rate 5/6, q = 4, K = 8000)**

| | | | | | | | | | | | | |
|---|---|---|---|---|---|---|---|---|---|---|---|---|
| 0 | 1265 | 699 | 614 | 1408 | 156 | 521 | 228 | 339 | 1539 | 1352 | 991 | 1125 |
| 1 | 543 | 198 | 1211 | 465 | 1063 | 638 | 826 | 965 | 121 | 1342 | 396 | 690 |
| | 2770212 | | | | | | | | | | | |

| | | |
|---|---|---|
| 3 | 252 | 557 |
| 0 | 576 | 1529 |
| 1 | 586 | 860 |
| 2 | 809 | 1079 |
| 3 | 1419 | 1114 |
| 0 | 1110 | 1399 |
| 1 | 665 | 148 |
| 2 | 615 | 926 |
| 3 | 356 | 1341 |
| 0 | 349 | 567 |
| 1 | 1192 | 901 |
| 2 | 1011 | 778 |
| 3 | 418 | 888 |
| 0 | 381 | 1478 |
| 1 | 1246 | 175 |
| 2 | 163 | 1284 |
| 3 | 480 | 1321 |

**5.** The method of claim 4, further comprising accumulating the parity bits by adding each parity bit content to the immediately preceding parity bit content.

**Patentansprüche**

**1.** Eine Low-Density-Parity-Check- (LDPC-) Codiervorrichtung (102), die zum Codieren von Daten, die eine Mehrzahl von Informationsbits beinhalten, in Broadcasting-Systemen verwendet wird, aufweisend:

eine Mehrzahl von Parallelakkumulationsmaschinen,

wobei eine Zahl $M$ von der Mehrzahl der Parallelakkumulationsmaschinen vorhanden ist,
wobei $M$ gleich 400 ist,
wobei:

die Informationsbits in der Mehrzahl der Parallelakkumulationsmaschinen gemäß einer Paritätsbitprüfungs-Matrix akkumuliert werden, die auf eine Form $H_{(N-K)xN} = [A_{(N-K)xK} \, B_{(N-K)x(N-K)}]$ begrenzt ist, wenn es sich bei B um ein treppenförmiges unteres Dreieck handelt;

ein erstes Informationsbit von einer ersten Gruppe von $M$ Informationsbits in der Mehrzahl von Informationsbits an einem ersten Satz von spezifischen Paritätsbit-Adressen, die durch die erste Reihe in einer gegebenen Tabelle der nachstehenden Tabellen 1 bis 4 entsprechend einer speziellen Code-Rate spezifiziert sind, in der Mehrzahl der Parallelakkumulationsmaschinen akkumuliert wird;

die Paritätsbit-Adresse in dem Encoder für jedes Element des ersten Satzes von spezifischen Paritätsbit-Adressen um einen vorbestimmten Versatz gemäß $\{x + m \bmod 400 \times q\} \bmod (N-K)$ für jedes anschließende Informationsbit $i_m$ nach dem ersten Informationsbit in der ersten Gruppe der $M$ Informationsbits erhöht wird, wobei $x$ die Paritätsbit-Adressen bezeichnet, die für das erste Informationsbit verwendet werden, das durch die erste Reihe in der gegebenen Tabelle spezifiziert ist;

jedes der anschließenden Informationsbits in der ersten Gruppe von $M$ Informationsbits an Paritätsbit-Adressen akkumuliert wird, die von den spezifischen Paritätsbit-Adressen um den vorbestimmten Versatz versetzt sind, bis ein $M+1$ Informationsbit erreicht wird;

eine nächste anschließende Gruppe von $M$ Informationsbits in der Mehrzahl der Informationsbits an einem weiteren Satz von spezifischen Paritätsbit-Adressen,
die durch alle Werte in der nächsten anschließenden Reihe in der gegebenen Tabelle gemäß $\{x + m \bmod 400 \times q\} \bmod (N-K)$ spezifiziert sind, unter Verwendung der Mehrzahl von Parallelakkumulationsmaschinen, akkumuliert werden, wobei die Paritätsbit-Adresse für jedes Element von dem weiteren Satz von spezifischen Paritätsbit-Adressen um den vorbestimmten Versatz gemäß $\{x + m \bmod 400 \times q\} \bmod (N-K)$ für jedes neue Informationsbit erhöht wird, wobei $x$ die Paritätsbit-Adressen bezeichnet, die für das erste Informationsbit in der nächsten anschließenden Gruppe der $M$ Informationsbits verwendet werden, die durch die nächste anschließende Reihe in der gegebenen Tabelle spezifiziert sind;

jedes Informationsbit in den aufeinander folgenden anschließenden Gruppen von $M$ Informationsbits unter Verwendung von zusätzlichen Sätze von spezifischen Paritätsbit-Adressen und vorbestimmten Versätzen akkumuliert wird, die genauso wie für den weiteren Satz von spezifischen Paritätsbit-Adressen an aufeinander folgenden anschließenden Reihen der gegebenen Tabelle berechnet werden, bis alle Informationsbits in der Mehrzahl der Informationsbits akkumuliert sind;

endgültige Paritätsbits gemäß $p_j = p_j \oplus p_{j-1}$ für $j = 1 \dots N-K-1$ erhalten werden, wobei der endgültige Inhalt einer jeweiligen Paritätsbit-Adresse gleich dem Paritätsbit $p_j$ ist;
$K$ eine Größe eines Informationsblocks und $N$ eine Größe eines Codeworts ist;
und
$q$ gleich $(N-K)/M$ ist.

**Tabelle 1. Adresse der Paritätsbit-Akkumulatoren (Rate 2/3, q = 10, K = 8000)**

| | | | | | | | | | | | | |
|---|---|---|---|---|---|---|---|---|---|---|---|---|
| 0 | 1531 | 876 | 3403 | 1298 | 3085 | 277 | 2316 | 1180 | 2988 | 3233 | 1851 | 2127 |
| 1 | 2423 | 2843 | 1600 | 3571 | 3509 | 1732 | 794 | 2985 | 264 | 1366 | 2309 | 1932 |
| 2 | 1826 | 3364 | | | | | | | | | | |
| 3 | 1464 | 3371 | | | | | | | | | | |
| 4 | 3055 | 3767 | | | | | | | | | | |
| 5 | 649 | 2172 | | | | | | | | | | |
| 6 | 2607 | 2095 | | | | | | | | | | |
| 7 | 1842 | 559 | | | | | | | | | | |
| 8 | 1630 | 3150 | | | | | | | | | | |
| 9 | 1608 | 3558 | | | | | | | | | | |
| 0 | 526 | 2323 | | | | | | | | | | |
| 1 | 505 | 2305 | | | | | | | | | | |
| 2 | 2317 | 2594 | | | | | | | | | | |
| 3 | 3684 | 171 | | | | | | | | | | |
| 4 | 3831 | 2296 | | | | | | | | | | |
| 5 | 753 | 1878 | | | | | | | | | | |

(fortgesetzt)

| 6 | 3908 | 1737 |
|---|---|---|
| 7 | 1132 | 2962 |
| 8 | 2340 | 1550 |
| 9 | 2519 | 1769 |

**Tabelle 2. Adresse der Paritätsbit-Akkumulatoren (Rate 1/2, q = 20, K = 8000)**

| | | | | | | | |
|---|---|---|---|---|---|---|---|
| 12 | 922 | 3230 | 286 | 6581 | 3068 | 2393 | 2290 |
| 13 | 1794 | 4368 | 7492 | 6487 | 354 | 4807 | 1829 |
| 14 | 5381 | 4074 | 4464 | 7568 | 1651 | 2664 | 5158 |
| 15 | 7823 | 4362 | 7543 | 6671 | 7320 | 2292 | 3669 |
| 16 | 5734 | 6843 | 6457 | 2774 | 1665 | 4823 | 1917 |
| 17 | 958 | 4478 | 4582 | 5620 | 6266 | 1796 | 1150 |
| 18 | 1730 | 7085 | 7145 | 6355 | 6101 | 5839 | 6442 |
| 19 | 4572 | 1780 | 1133 | 4219 | 5778 | 1055 | 5529 |
| 0 | 3597 | 6167 | | | | | |
| 1 | 2544 | 53 | | | | | |
| 2 | 5955 | 169 | | | | | |
| 3 | 3051 | 1026 | | | | | |
| 4 | 3420 | 3917 | | | | | |
| 5 | 5259 | 272 | | | | | |
| 6 | 1313 | 3599 | | | | | |
| 7 | 6956 | 1991 | | | | | |
| 8 | 4105 | 2744 | | | | | |
| 9 | 4106 | 7001 | | | | | |
| 10 | 3467 | 6115 | | | | | |
| 11 | 7948 | 4436 | | | | | |

**Tabelle 3. Adresse der Paritätsbitakkumulatoren (Rate 3/4, q = 6, K = 7200)**

| | | | | | | | | | | | |
|---|---|---|---|---|---|---|---|---|---|---|---|
| 0 | 1071 | 1268 | 595 | 804 | 1947 | 1564 | 713 | 1736 | 1618 | 2281 | 317 |
| 1 | 1382 | 275 | 1763 | 452 | 2254 | 675 | 1105 | 1266 | 1824 | 1161 | 1586 |
| 2 | 617 | 840 | | | | | | | | | |
| 3 | 144 | 2101 | | | | | | | | | |
| 4 | 2293 | 874 | | | | | | | | | |
| 5 | 2104 | 2211 | | | | | | | | | |
| 0 | 802 | 368 | | | | | | | | | |
| 1 | 1873 | 202 | | | | | | | | | |
| 2 | 261 | 1925 | | | | | | | | | |
| 3 | 1806 | 711 | | | | | | | | | |
| 4 | 314 | 2214 | | | | | | | | | |
| 5 | 1265 | 139 | | | | | | | | | |
| 0 | 316 | 732 | | | | | | | | | |
| 1 | 291 | 1930 | | | | | | | | | |
| 2 | 942 | 1067 | | | | | | | | | |
| 3 | 1333 | 121 | | | | | | | | | |
| 4 | 698 | 2270 | | | | | | | | | |
| 5 | 1127 | 1197 | | | | | | | | | |

**Tabelle 4: Adresse der Paritätsbit-Akkumulatoren (Rate 5/6, q = 4, K = 8000)**

| 0 | 1265 | 699 | 614 | 1408 | 156 | 521 | 228 | 339 | 1539 | 1352 | 991 | 1125 |
|---|------|-----|------|------|------|-----|-----|-----|------|------|-----|------|
| 1 | 543 | 198 | 1211 | 465 | 1063 | 638 | 826 | 965 | 121 | 1342 | 396 | 690 |
| 2 | 770 | 212 | | | | | | | | | | |
| 3 | 252 | 557 | | | | | | | | | | |
| 0 | 576 | 1529 | | | | | | | | | | |
| 1 | 586 | 860 | | | | | | | | | | |
| 2 | 809 | 1079 | | | | | | | | | | |
| 3 | 1419 | 1114 | | | | | | | | | | |
| 0 | 1110 | 1399 | | | | | | | | | | |
| 1 | 665 | 148 | | | | | | | | | | |
| 2 | 615 | 926 | | | | | | | | | | |
| 3 | 356 | 1341 | | | | | | | | | | |
| 0 | 349 | 567 | | | | | | | | | | |
| 1 | 1192 | 901 | | | | | | | | | | |
| 2 | 1011 | 778 | | | | | | | | | | |
| 3 | 418 | 888 | | | | | | | | | | |
| 0 | 381 | 1478 | | | | | | | | | | |
| 1 | 1246 | 175 | | | | | | | | | | |
| 2 | 163 | 1284 | | | | | | | | | | |
| 3 | 480 | 1321 | | | | | | | | | | |

2. System nach Anspruch 1, wobei die LDPC-Codes in einem Multiple-Input-Multiple-Output- (MIMO-) System verwendet werden.

3. System nach Anspruch 2, ferner aufweisend ein Akkumulieren der Paritätsbits durch Addieren eines jeden Paritätsbit-Inhalts zu dem unmittelbar vorhergehenden Paritätsbit-Inhalt.

4. Verfahren zum Codieren von Daten, die eine Mehrzahl von Informationsbits beinhalten, unter Verwendung von LDPC-Codes, wobei das Verfahren folgende Schritte beinhaltet:

a) Akkumulieren, mit einem Encoder, einer ersten Gruppe von $M$ Informationsbits in der Mehrzahl von Informationsbits unter Verwendung von $M$ Parallelakkumulationsmaschinen an einem ersten Satz von spezifischen Paritätsbit-Adressen, die durch die erste Reihe in einer gegebenen Tabelle der nachstehenden Tabellen 1 - 4 entsprechend einer speziellen Code-Rate spezifiziert sind, in der Mehrzahl von Parallelakkumulationsmaschinen, wobei eine Akkumulation gemäß einer Paritätsprüfungs-Matrix der Form $H_{(N-K)xN} = [A_{(N-K)xK} \; B_{(N-K)x(N-K)}]$ erfolgt, wenn $B$ ein treppenförmiges unteres Dreieck ist, und wenn M = 400;

b) Erhöhen der Paritätsbit-Adresse in dem Encoder für jedes Element des ersten Satzes von spezifischen Paritätsbit-Adressen um einen vorbestimmten Versatz gemäß $\{x + m \bmod 400 \, x \, q\} \bmod (N\text{-}K)$ für jedes anschließende Informationsbit $i_m$, nach dem ersten Informationsbit in der ersten Gruppe von $M$ Informationsbits, wobei $x$ die Paritätsbit-Adressen bezeichnet, die für das erste Informationsbit verwendet werden, das durch die erste Reihe in der gegebenen Tabelle spezifiziert ist;

c) Akkumulieren eines jeden der anschließenden Informationsbits in der ersten Gruppe von $M$ Informationsbits bei Paritätsbit-Adressen, die von den spezifischen Paritätsbit-Adressen um den vorbestimmten Versatz versetzt sind, bis ein $M + 1$ Informationsbit erreicht wird;

d) Akkumulieren einer nächsten anschließenden Gruppe von $M$ Informationsbits in der Mehrzahl von Informationsbits an einem weiteren Satz von spezifischen Paritätsbit-Adressen, die durch alle Werte in der nächsten anschließenden Reihe in der gegebenen Tabelle gemäß $\{x + m \bmod 400 \, x \, q\} \bmod (N\text{-}K)$ spezifiziert sind, unter Verwendung der Mehrzahl von Parallelakkumulationsmaschinen, wobei die Paritätsbit-Adresse für jedes Element des weiteren Satzes von spezifischen Paritätsbit-Adressen um den vorbestimmten Versatz gemäß $\{x + m \bmod 400 \, x \, q\} \bmod (N\text{-}K)$ für jedes neue Informationsbit erhöht wird, wobei $x$ die Paritätsbit-Adressen bezeichnet, die für das erste Informationsbit in der nächsten anschließenden Gruppe von $M$ Informationsbits verwendet werden, die durch die nächste anschließende Reihe in der gegebenen Tabelle spezifiziert sind; und

e) Akkumulieren eines jeweiligen Informationsbits in aufeinander folgenden anschließenden Gruppen der *M* Informationsbits unter Verwendung zusätzlicher Sätze von spezifischen Paritätsbit-Adressen und vorbestimmten Versätzen, die genauso wie für Schritt d) bei aufeinander folgenden anschließenden Reihen der gegebenen Tabelle berechnet werden, bis alle Informationsbits in der Mehrzahl von Informationsbits akkumuliert sind,

f) endgültige Paritätsbits gemäß $p_j = p_j \oplus p_{i-1}$ für $j = 1 \ldots N\text{-}K\text{-}1$ erhalten werden, wenn der endgültige Inhalt einer jeden Paritätsbit-Adresse gleich dem Paritätsbit $p_j$ ist;

g) *K* eine Größe eines Informationsblocks und *N* eine Größe eines Codeworts ist; und q gleich *(N-K)* / *M* ist.

**Tabelle 1. Adresse der Paritätsbit-Akkumulatoren (Rate 2/3, q = 10, K = 8000)**

| | | | | | | | | | | | | |
|---|---|---|---|---|---|---|---|---|---|---|---|---|
| 0 | 1531 | 876 | 3403 | 1298 | 3085 | 277 | 2316 | 1180 | 2988 | 3233 | 1851 | 2127 |
| 1 | 2423 | 2843 | 1600 | 3571 | 3509 | 1732 | 794 | 2985 | 264 | 1366 | 2309 | 1932 |
| 2 | 1826 | 3364 | | | | | | | | | | |
| 3 | 1464 | 3371 | | | | | | | | | | |
| 4 | 3055 | 3767 | | | | | | | | | | |
| 5 | 649 | 2172 | | | | | | | | | | |
| 6 | 2607 | 2095 | | | | | | | | | | |
| 7 | 1842 | 559 | | | | | | | | | | |
| 8 | 1630 | 3150 | | | | | | | | | | |
| 9 | 1608 | 3558 | | | | | | | | | | |
| 0 | 526 | 2323 | | | | | | | | | | |
| 1 | 505 | 2305 | | | | | | | | | | |
| 2 | 2317 | 2594 | | | | | | | | | | |
| 3 | 3684 | 171 | | | | | | | | | | |
| 4 | 3831 | 2296 | | | | | | | | | | |
| 5 | 753 | 1878 | | | | | | | | | | |
| 6 | 3908 | 1737 | | | | | | | | | | |
| 7 | 1132 | 2962 | | | | | | | | | | |
| 8 | 2340 | 1550 | | | | | | | | | | |
| 9 | 2519 | 1769 | | | | | | | | | | |

**Tabelle 2. Adresse der Paritätsbit-Akkumulatoren (Rate 1/2, q = 20, K = 8000)**

| | | | | | | | |
|---|---|---|---|---|---|---|---|
| 12 | 922 | 3230 | 286 | 6581 | 3068 | 2393 | 2290 |
| 13 | 1749 | 4368 | 7492 | 6487 | 354 | 4807 | 1829 |
| 14 | 5381 | 4074 | 4464 | 7568 | 1651 | 2664 | 5158 |
| 15 | 7823 | 4362 | 7543 | 6671 | 7320 | 2292 | 3696 |
| 16 | 5734 | 6843 | 6457 | 2774 | 1665 | 4823 | 1917 |
| 17 | 958 | 4478 | 4582 | 5620 | 6266 | 1796 | 1150 |
| 18 | 1730 | 7085 | 7145 | 6355 | 6101 | 5839 | 6442 |
| 19 | 4572 | 1780 | 1133 | 4219 | 55778 | 1055 | 5529 |
| 0 | 3597 | 6167 | | | | | |
| 1 | 2544 | 53 | | | | | |
| 2 | 5955 | 169 | | | | | |
| 3 | 3051 | 1026 | | | | | |
| 4 | 3420 | 3917 | | | | | |
| 5 | 5259 | 272 | | | | | |
| 6 | 1313 | 3599 | | | | | |
| 7 | 6956 | 1991 | | | | | |
| 8 | 4105 | 2744 | | | | | |
| 9 | 4106 | 7001 | | | | | |
| 10 | 3467 | 6115 | | | | | |
| 11 | 7948 | 4436 | | | | | |

**Tabelle 3: Adresse der Paritätsbit-Akkumulatoren (Rate 3/4, q = 6, K = 7200)**

| | | | | | | | | | | | |
|---|---|---|---|---|---|---|---|---|---|---|---|
| 0 | 1071 | 1268 | 595 | 804 | 1947 | 1564 | 713 | 1736 | 1618 | 2281 | 317 |
| 1 | 1382 | 275 | 1763 | 452 | 2254 | 675 | 1105 | 1266 | 1824 | 1161 | 1586 |
| 2 | 617 | 840 | | | | | | | | | |
| 3 | 144 | 2102 | | | | | | | | | |
| 4 | 2293 | 874 | | | | | | | | | |
| 5 | 2104 | 2211 | | | | | | | | | |
| 0 | 802 | 368 | | | | | | | | | |
| 1 | 1873 | 202 | | | | | | | | | |
| 2 | 261 | 1925 | | | | | | | | | |
| 3 | 1806 | 711 | | | | | | | | | |
| 4 | 314 | 2214 | | | | | | | | | |
| 5 | 1265 | 139 | | | | | | | | | |
| 0 | 316 | 732 | | | | | | | | | |
| 1 | 291 | 1930 | | | | | | | | | |
| 2 | 942 | 1067 | | | | | | | | | |
| 3 | 1333 | 121 | | | | | | | | | |
| 4 | 698 | 2270 | | | | | | | | | |
| 5 | 1127 | 1197 | | | | | | | | | |

**Tabelle 4. Adresse der Paritätsbit-Akkumulatoren (Rate 5/6, q = 4, K = 8000)**

| | | | | | | | | | | | | |
|---|---|---|---|---|---|---|---|---|---|---|---|---|
| 0 | 1265 | 699 | 614 | 1408 | 156 | 521 | 228 | 339 | 1539 | 1352 | 991 | 1125 |
| 1 | 543 | 198 | 1211 | 465 | 1063 | 638 | 826 | 965 | 121 | 1342 | 396 | 690 |
| 2 | 770 | 212 | | | | | | | | | | |
| 3 | 252 | 557 | | | | | | | | | | |
| 0 | 576 | 1529 | | | | | | | | | | |
| 1 | 586 | 860 | | | | | | | | | | |
| 2 | 809 | 1079 | | | | | | | | | | |
| 3 | 1419 | 1114 | | | | | | | | | | |
| 0 | 1110 | 1399 | | | | | | | | | | |
| 1 | 665 | 148 | | | | | | | | | | |
| 2 | 615 | 926 | | | | | | | | | | |
| 3 | 356 | 1341 | | | | | | | | | | |
| 0 | 349 | 567 | | | | | | | | | | |
| 1 | 1192 | 901 | | | | | | | | | | |
| 2 | 111 | 778 | | | | | | | | | | |
| 3 | 418 | 888 | | | | | | | | | | |
| 0 | 381 | 1478 | | | | | | | | | | |
| 1 | 1246 | 175 | | | | | | | | | | |
| 2 | 163 | 1284 | | | | | | | | | | |
| 3 | 480 | 1321 | | | | | | | | | | |

**5.** Verfahren nach Anspruch 4, ferner beinhaltend ein Akkumulieren der Paritätsbits durch Addieren eines jeden Paritätsbit-Inhalts zu dem unmittelbar vorhergehenden Paritätsbit-Inhalt.

**Revendications**

**1.** Codeur (102) avec contrôle de parité à faible densité (LDPC pour "Low Density Parity Check") utilisé pour coder des données comprenant une pluralité de bits d'information dans des systèmes de diffusion, comprenant :

une pluralité de moteurs de cumul en parallèle,

dans lequel il y a un certain nombre, M, de la pluralité de moteurs de cumul en parallèle,

dans lequel M est égal à 400,

dans lequel :

des bits d'information sont cumulés dans la pluralité de moteurs de cumul en parallèle suivant une matrice de contrôle de bits de parité limitée à une forme $H_{(N-K) \times N} = [A_{(N-K) \times K} \ B_{(N-K) \times (N-K)}]$ où B est triangulaire inférieur en escalier ;

un premier bit d'information d'un premier groupe de M bits d'information dans la pluralité de bits d'information est cumulé à un premier ensemble d'adresses spécifiques de bit de parité, spécifié par la première ligne dans un tableau donné des tableaux 1 à 4 ci-dessous correspondant à un taux de code particulier, dans la pluralité de moteurs de cumul en parallèle ;

l'adresse de bit de parité dans le codeur pour chaque membre du premier ensemble d'adresses spécifiques de bit de parité est accrue d'un décalage prédéterminé selon $\{x + m \bmod 400 \times q\} \bmod(N - K)$ pour chaque bit, $i_m$, d'information subséquent après le premier bit d'information dans le premier groupe de M bits d'information, où x désigne les adresses de bits de parité utilisées pour le premier bit d'information spécifié par la première ligne dans le tableau donné ;

chacun des bits d'information subséquents dans le premier groupe de M bits d'information est cumulé à des adresses de bit de parité qui sont décalées, du décalage prédéterminé, par rapport aux adresses spécifiques de bit de parité jusqu'à ce que soit atteint un bit M+1 d'information ;

un groupe subséquent suivant de M bits d'information de la pluralité de bits d'information est cumulé à un autre ensemble d'adresses spécifiques de bit de parité spécifié par toutes les valeurs dans la ligne subséquente suivante du tableau donné selon $\{x + m \bmod 400 \times q\} \bmod(N - K)$, en utilisant la pluralité de moteurs de cumul en parallèle, dans lequel l'adresse de bit de parité pour chaque membre de l'autre ensemble d'adresses spécifiques de bit de parité est accrue du décalage prédéterminé selon $\{x + m \bmod 400 \times q\} \bmod(N - K)$ pour chaque nouveau bit d'information, où x désigne les adresses de bit de parité utilisées pour le premier bit d'information dans le groupe subséquent suivant de M bits d'information spécifié par la ligne subséquente suivante dans le tableau donné ;

chaque bit d'information dans des groupes subséquents successifs de M bits d'information est cumulé en utilisant des ensembles supplémentaires d'adresses spécifiques de bit de parité et des décalages prédéterminés calculés de la même façon que pour l'autre ensemble d'adresses spécifiques de bit de parité au niveau de lignes subséquentes successives du tableau donné jusqu'à ce que soient cumulés tous les bits d'information de la pluralité de bits d'information ;

les bits finals de parité sont obtenus selon $p_j = p_j \oplus p_{j-1}$, pour j = 1... N-K-1 où le contenu final de chaque adresse de bit de parité est égal au bit de parité, $p_j$;

K est la taille d'un bloc d'information et N est la taille d'un mot de code ; et

q est égal à (N - K)/M.

Tableau 1. Adresse des accumulateurs de bits de parité (Taux 2/3, q = 10, K = 8000)

| | | | | | | | | | | | | |
|---|---|---|---|---|---|---|---|---|---|---|---|---|
| 0 | 1531 | 876 | 3403 | 1298 | 3085 | 277 | 23161 | 1180 | 2988 | 3233 | 1851 | 2127 |
| 1 | 2423 | 2843 | 1600 | 3571 | 3509 | 1732 | 794 | 2985 | 264 | 1366 | 2309 | 1932 |
| 2 | 1826 | 3364 | | | | | | | | | | |
| 3 | 1464 | 3371 | | | | | | | | | | |
| 4 | 3055 | 3767 | | | | | | | | | | |
| 5 | 649 | 2172 | | | | | | | | | | |
| 6 | 2607 | 2095 | | | | | | | | | | |
| 7 | 1842 | 559 | | | | | | | | | | |
| 8 | 1630 | 3150 | | | | | | | | | | |
| 9 | 1608 | 3558 | | | | | | | | | | |
| 0 | 526 | 2323 | | | | | | | | | | |
| 1 | 505 | 2305 | | | | | | | | | | |
| 2 | 2317 | 2594 | | | | | | | | | | |
| 3 | 3684 | 171 | | | | | | | | | | |
| 4 | 3831 | 2296 | | | | | | | | | | |
| 5 | 753 | 1878 | | | | | | | | | | |
| 6 | 3908 | 1737 | | | | | | | | | | |

(suite)

| 7 | 1132 | 2962 |
| 8 | 2340 | 1550 |
| 9 | 2519 | 1769 |

Tableau 2. Adresse des accumulateurs de bits de parité (Taux 1/2, q = 20, K = 8000)

| 12 | 922 | 3230 | 286 | 6581 | 3068 | 2393 | 2290 |
|----|------|------|------|------|------|------|------|
| 13 | 1749 | 4368 | 7492 | 6487 | 354 | 4807 | 1829 |
| 14 | 5381 | 4074 | 4464 | 7568 | 1651 | 2664 | 5158 |
| 15 | 7823 | 4362 | 7543 | 6671 | 7320 | 2292 | 3696 |
| 16 | 5734 | 6843 | 6457 | 2774 | 1665 | 4823 | 1917 |
| 17 | 958 | 4478 | 4582 | 5620 | 6266 | 1796 | 1150 |
| 18 | 1730 | 7085 | 7145 | 6355 | 6101 | 5839 | 6442 |
| 19 | 4572 | 1780 | 1133 | 4219 | 5778 | 1055 | 5529 |
| 0 | 3597 | 6167 | | | | | |
| 1 | 2544 | 53 | | | | | |
| 2 | 5955 | 169 | | | | | |
| 3 | 3051 | 1026 | | | | | |
| 4 | 3420 | 3917 | | | | | |
| 5 | 5259 | 272 | | | | | |
| 6 | 1313 | 3599 | | | | | |
| 7 | 6956 | 1991 | | | | | |
| 8 | 4105 | 2744 | | | | | |
| 9 | 4106 | 7001 | | | | | |
| 10 | 3467 | 6115 | | | | | |
| 11 | 7948 | 4436 | | | | | |

Tableau 3. Adresse des accumulateurs de bits de parité (Taux 3/4, q = 6, K = 7200)

| 0 | 1071 | 1268 | 595 | 804 | 1947 | 1564 | 713 | 1736 | 1619 | 2281 | 317 |
|----|------|------|------|------|------|------|------|------|------|------|------|
| 1 | 1382 | 275 | 1763 | 452 | 2254 | 675 | 1105 | 1266 | 1824 | 1161 | 1586 |
| 2 | 617 | 840 | | | | | | | | | |
| 3 | 144 | 2101 | | | | | | | | | |
| 4 | 2293 | 874 | | | | | | | | | |
| 5 | 2104 | 2211 | | | | | | | | | |
| 0 | 802 | 368 | | | | | | | | | |
| 11 | 873 | 202 | | | | | | | | | |
| 2 | 261 | 1925 | | | | | | | | | |
| 3 | 1806 | 711 | | | | | | | | | |
| 4 | 314 | 2214 | | | | | | | | | |
| 5 | 1265 | 139 | | | | | | | | | |
| 0 | 316 | 732 | | | | | | | | | |
| 1 | 291 | 1930 | | | | | | | | | |
| 2 | 942 | 1067 | | | | | | | | | |
| 3 | 1333 | 121 | | | | | | | | | |
| 4 | 698 | 2270 | | | | | | | | | |
| 5 | 1127 | 1197 | | | | | | | | | |

Tableau 4. Adresse des accumulateurs de bits de parité (Taux 5/6, q = 4, K = 8000)

| | | | | | | | | | | | | |
|---|---|---|---|---|---|---|---|---|---|---|---|---|
| 0 | 1265 | 699 | 614 | 1408 | 156 | 521 | 228 | 339 | 1539 | 1352 | 991 | 1125 |
| 1 | 543 | 198 | 1211 | 465 | 1063 | 638 | 826 | 965 | 121 | 1342 | 396 | 690 |
| 2 | 770 | 212 | | | | | | | | | | |
| 3 | 252 | 557 | | | | | | | | | | |
| 0 | 576 | 529 | | | | | | | | | | |
| 1 | 586 | 860 | | | | | | | | | | |
| 2 | 809 | 1079 | | | | | | | | | | |
| 3 | 1419 | 1114 | | | | | | | | | | |
| 0 | 1110 | 1399 | | | | | | | | | | |
| 1 | 665 | 148 | | | | | | | | | | |
| 2 | 615 | 926 | | | | | | | | | | |
| 3 | 356 | 1341 | | | | | | | | | | |
| 0 | 349 | 567 | | | | | | | | | | |
| 1 | 1192 | 901 | | | | | | | | | | |
| 2 | 1011 | 778 | | | | | | | | | | |
| 3 | 418 | 888 | | | | | | | | | | |
| 0 | 381 | 1478 | | | | | | | | | | |
| 1 | 1246 | 175 | | | | | | | | | | |
| 2 | 163 | 1284 | | | | | | | | | | |
| 3 | 480 | 1321 | | | | | | | | | | |

2. Système selon la revendication 1, dans lequel les codes avec LDPC sont utilisés dans un système à entrées multiples, sorties multiples (MIMO).

3. Système selon la revendication 2, comprenant en outre le cumul des bits de parité en additionnant chaque contenu de bit de parité au contenu de bit de parité précédant immédiatement.

4. Procédé de codage de données comprenant une pluralité de bits d'information en utilisant des codes avec contrôle de parité à faible densité (LDPC), comprenant :

a) le cumul, à l'aide d'un codeur, d'un premier groupe de M bits d'information de la pluralité de bits d'information en utilisant une pluralité de M moteurs de cumul en parallèle à un premier ensemble d'adresses spécifiques de bit de parité, spécifié par la première ligne dans un tableau donné des tableaux 1 à 4 ci-dessous correspondant à un taux de code particulier, dans la pluralité de moteurs de cumul en parallèle, dans lequel le cumul se fait suivant une matrice de contrôle de parité de la forme $H_{(N-K) \times N} = [A_{(N-K) \times K} B_{(N-K) \times (N-K)}]$ où B est triangulaire inférieur en escalier, et dans lequel M est égal à 400 ;

b) l'augmentation de l'adresse de bit de parité dans le codeur pour chaque membre du premier ensemble d'adresses spécifiques de bit de parité d'un décalage prédéterminé selon {x + m mod 400 × q} mod(N - K) pour chaque bit, $i_m$, d'information subséquent après le premier bit d'information dans le premier groupe de M bits d'information, où x désigne les adresses de bits de parité utilisées pour le premier bit d'information spécifié par la première ligne dans le tableau donné ;

c) le cumul de chacun des bits d'information subséquents dans le premier groupe de M bits d'information à des adresses de bit de parité qui sont décalées, du décalage prédéterminé, par rapport aux adresses spécifiques de bit de parité jusqu'à ce que soit atteint un bit M+1 d'information ;

d) le cumul d'un groupe subséquent suivant de M bits d'information de la pluralité de bits d'information à un autre ensemble d'adresses spécifiques de bit de parité spécifié par toutes les valeurs dans la ligne subséquente suivante du tableau donné selon {x + m mod 400 × q} mod(N - K), en utilisant la pluralité de moteurs de cumul en parallèle, dans lequel l'adresse de bit de parité pour chaque membre de l'autre ensemble d'adresses spécifiques de bit de parité est accrue du décalage prédéterminé selon {x + m mod 400 × q} mod(N - K) pour chaque nouveau bit d'information, où x désigne les adresses de bit de parité utilisées pour le premier bit d'information dans le groupe subséquent suivant de M bits d'information spécifié par la ligne subséquente suivante dans le tableau donné ; et

e) le cumul de chaque bit d'information dans des groupes subséquents successifs de M bits d'information est cumulé en utilisant des ensembles supplémentaires d'adresses spécifiques de bit de parité et des décalages prédéterminés calculés de la même façon que pour l'étape d) au niveau de lignes subséquentes successives du tableau donné jusqu'à ce que soient cumulés tous les bits d'information de la pluralité de bits d'information ;
f) les bits finals de parité sont obtenus selon $p_j = p_j \oplus p_{j-1}$, pour j = 1... N-K-1 où le contenu final de chaque adresse de bit de parité est égal au bit de parité $p_j$ ;
g) K est la taille d'un bloc d'information et N est la taille d'un mot de code ; et q est égal à (N - K)/M.

Tableau 1. Adresse des accumulateurs de bits de parité (Taux 2/3, q = 10, K = 8000)

| | | | | | | | | | | | |
|---|---|---|---|---|---|---|---|---|---|---|---|
| 0 | 1531 | 876 | 3403 | 1298 | 3085 | 277 | 2316 | 1180 | 2988 | 3233 | 1851 | 2127 |
| 1 | 2423 | 2843 | 1600 | 3571 | 3509 | 1732 | 794 | 2985 | 264 | 1366 | 2309 | 1932 |
| 2 | 1826 | 3364 | | | | | | | | | | |
| 3 | 1464 | 3371 | | | | | | | | | | |
| 4 | 3055 | 3767 | | | | | | | | | | |
| 5 | 649 | 2172 | | | | | | | | | | |
| 6 | 2607 | 2095 | | | | | | | | | | |
| 7 | 1842 | 559 | | | | | | | | | | |
| 8 | 1630 | 3150 | | | | | | | | | | |
| 9 | 1608 | 3558 | | | | | | | | | | |
| 0 | 526 | 2323 | | | | | | | | | | |
| 1 | 505 | 2305 | | | | | | | | | | |
| 2 | 2317 | 2594 | | | | | | | | | | |
| 3 | 3684 | 171 | | | | | | | | | | |
| 4 | 3831 | 2296 | | | | | | | | | | |
| 5 | 753 | 1878 | | | | | | | | | | |
| 6 | 3908 | 1737 | | | | | | | | | | |
| 7 | 1132 | 2962 | | | | | | | | | | |
| 8 | 2340 | 1550 | | | | | | | | | | |
| 9 | 2519 | 1769 | | | | | | | | | | |

Tableau 2. Adresse des accumulateurs de bits de parité (Taux 1/2, q = 20, K = 8000)

| | | | | | | | |
|---|---|---|---|---|---|---|---|
| 12 | 922 | 3230 | 286 | 6581 | 3068 | 2393 | 2290 |
| 13 | 1749 | 4368 | 7492 | 6487 | 354 | 4807 | 1829 |
| 14 | 5381 | 4074 | 4464 | 7568 | 1651 | 2664 | 5158 |
| 15 | 7823 | 4362 | 7543 | 6671 | 7320 | 2292 | 3696 |
| 16 | 5734 | 6843 | 6457 | 2774 | 1665 | 4823 | 1917 |
| 17 | 958 | 4478 | 4582 | 5620 | 6266 | 1796 | 1150 |
| 18 | 1730 | 7085 | 7145 | 6355 | 6101 | 5839 | 6442 |
| 19 | 4572 | 1780 | 1133 | 4219 | 5778 | 1055 | 5529 |
| 0 | 3597 | 6167 | | | | | |
| 1 | 2544 | 53 | | | | | |
| 2 | 5955 | 169 | | | | | |
| 3 | 3051 | 1026 | | | | | |
| 4 | 3420 | 3917 | | | | | |
| 5 | 5259 | 272 | | | | | |
| 6 | 1313 | 3599 | | | | | |
| 7 | 6956 | 1991 | | | | | |
| 8 | 4105 | 2744 | | | | | |
| 9 | 4106 | 7001 | | | | | |
| 10 | 3467 | 6115 | | | | | |
| 11 | 7948 | 4436 | | | | | |

Tableau 3. Adresse des accumulateurs de bits de parité (Taux 3/4, q = 6, K = 7200)

| 0 | 1071 | 1268 | 595 | 804 | 1947 | 1564 | 713 | 1736 | 1618 | 2281 | 317 |
|---|------|------|------|-----|------|------|------|------|------|------|------|
| 1 | 1382 | 275 | 1763 | 452 | 2254 | 675 | 1105 | 1266 | 1824 | 1161 | 1586 |
| 2 | 617 | 840 | | | | | | | | | |
| 3 | 144 | 2101 | | | | | | | | | |
| 4 | 2293 | 874 | | | | | | | | | |
| 5 | 2104 | 2211 | | | | | | | | | |
| 0 | 802 | 368 | | | | | | | | | |
| 1 | 1873 | 202 | | | | | | | | | |
| 2 | 261 | 1925 | | | | | | | | | |
| 3 | 1806 | 711 | | | | | | | | | |
| 4 | 314 | 2214 | | | | | | | | | |
| 5 | 1265 | 139 | | | | | | | | | |
| 0 | 316 | 732 | | | | | | | | | |
| 1 | 291 | 1930 | | | | | | | | | |
| 2 | 942 | 1067 | | | | | | | | | |
| 3 | 1333 | 121 | | | | | | | | | |
| 4 | 698 | 2270 | | | | | | | | | |
| 5 | 1127 | 1197 | | | | | | | | | |

Tableau 4. Adresse des accumulateurs de bits de parité (Taux 5/6, q = 4, K = 8000)

| 0 | 1265 | 699 | 614 | 1408 | 156 | 521 | 228 | 339 | 1539 | 1352 | 991 | 1125 |
|---|------|-----|------|------|------|------|------|------|------|------|------|------|
| 1 | 543 | 198 | 1211 | 465 | 1063 | 638 | 826 | 965 | 121 | 1342 | 396 | 690 |
| 2 | 770 | 212 | | | | | | | | | | |
| 3 | 252 | 557 | | | | | | | | | | |
| 0 | 576 | 1529 | | | | | | | | | | |
| 1 | 586 | 860 | | | | | | | | | | |
| 2 | 8091 | 079 | | | | | | | | | | |
| 3 | 1419 | 1114 | | | | | | | | | | |
| 0 | 1110 | 1399 | | | | | | | | | | |
| 1 | 665 | 148 | | | | | | | | | | |
| 2 | 615 | 926 | | | | | | | | | | |
| 3 | 356 | 1341 | | | | | | | | | | |
| 0 | 349 | 567 | | | | | | | | | | |
| 1 | 1192 | 901 | | | | | | | | | | |
| 2 | 1011 | 778 | | | | | | | | | | |
| 3 | 418 | 888 | | | | | | | | | | |
| 0 | 381 | 1478 | | | | | | | | | | |
| 1 | 1246 | 175 | | | | | | | | | | |
| 2 | 163 | 1284 | | | | | | | | | | |
| 3 | 480 | 1321 | | | | | | | | | | |

5. Procédé selon la revendication 4, comprenant en outre le cumul des bits de parité en additionnant chaque contenu de bit de parité au contenu de bit de parité précédant immédiatement.

**FIG. 1**

EP 1 790 083 B1

208

$$B = \begin{bmatrix} 1 & & & & & \\ 1 & 1 & & & \Large 0 & \\ & 1 & 1 & & & \\ & & 1 & \ddots & & \\ & & & \ddots & & \\ \Large 0 & & & \ddots & 1 & \\ & & & & 1 & 1 \end{bmatrix}$$

**FIG. 2**

FIG.3A

FIG.3B

FIG.3C

**FIG. 4A**

**FIG. 4B**

**FIG. 4C**

**FIG. 5**

CONFIGURING A PLURALITY OF PARALLEL
ACCUMULATION ENGINES, A NUMBER OF
THE PLURALITY OF PARALLEL ACCUMULATION
ENGINES EQUAL TO M

500

ACCUMULATING A FIRST INFORMATION BIT AT A FIRST
SET OF SPECIFIC PARITY BIT ADDRESSES USING THE
PLURALITY OF PARALLEL ACCUMULATION ENGINES

502

INCREASING A PARITY BIT ADDRESS FOR EACH
MEMBER OF THE FIRST SET OF SPECIFIC PARITY BIT
ADDRESSES BY A PRE-DETERMINED OFFSET FOR EACH
NEW INFORMATION BIT

504

ACCUMULATING SUBSEQUENT INFORMATION BITS
AT PARITY BIT ADDRESSES THAT ARE OFFSET FROM
THE SPECIFIC PARITY BIT ADDRESSES BY THE
PRE-DETERMINED OFFSET UNTIL
AN M+1 INFORMATION BIT IS REACHED

506

ACCUMULATING THE NEXT M INFORMATION BITS AT
A SECOND SET OF SPECIFIC PARITY BIT ADRESSES
USING THE PLURALITY OF
PARALLEL ACCUMULATION ENGINES

508

512

REPEAT UNTIL
INFORMATION BITS
ARE EXHAUSTED

INCREASING A PARITY BIT ADDRESS FOR EACH
MEMBER OF THE SECOND SET OF SPECIFIC PARITY
BIT ADDRESSES BY THE PRE-DETERMINED
OFFSET FOR EACH NEW INFORMATION BIT

510